# EUROPEAN PATENT APPLICATION

(11) **EP 4 672 935 A1**
(43) Date of publication of application: **31.12.2025**
(21) Application number: 24795640.2
(22) Date of filing: 13.03.2024
(51) Int. Cl.: H10K 59/00, G09G 3/3233, H10D 86/00, H10K 59/121, H10K 71/00

(54) **DISPLAY SUBSTRATE AND MANUFACTURING METHOD THEREFOR, AND DISPLAY DEVICE**

(30) Priority: 26.04.2023 CN 202310466298
(71) Applicant: BOE Technology Group Co., Ltd., Beijing 100015 (CN); Hefei BOE Joint Technology Co., Ltd., Hefei, Anhui 230012 (CN)
(72) Inventor: YUAN, Can, Beijing 100176 (CN); LI, Yongqian, Beijing 100176 (CN)
(74) Representative: Durán-Corretjer, S.L.P.
(86) International application number: PCT/CN2024/081402
(87) International publication number: WO 2024/222257

(57) **Abstract**

Embodiments of the present disclosure provide a display substrate and a manufacturing method therefor, and a display device. The display substrate comprises a plurality of repeating units, and each repeating unit comprises a display region and a light-transmitting region; the display region comprises a plurality of sub-pixels, and each sub-pixel comprises a pixel driving circuit; the pixel driving circuit comprises a first transistor, a second transistor, a third transistor, and a storage capacitor; a first electrode of the first transistor is connected to a data signal line, and a second electrode of the first transistor is connected to a gate electrode of the second transistor and a first end of the storage capacitor, respectively; a first electrode of the second transistor is connected to a first power line, and a second electrode of the second transistor is connected to a second electrode of the third transistor and a second end of the storage capacitor, respectively; a first electrode of the third transistor is connected to a compensation signal line; in at least one sub-pixel, a gate electrode of the first transistor and a gate electrode of the third transistor are connected to a same scanning signal line.

## Description

The present application claims priority to Chinese Patent Application No. 202310466298.4 filed to the CNIPA on April 26, 2023 and entitled "Display Substrate and Manufacturing Method Therefor, and Display Device", contents of which should be construed as being incorporated into the present application by reference.

### Technical Field

The present disclosure relates to, but is not limited to, the field of display technologies, and in particular to a display substrate, a manufacturing method therefor, and a display device.

### Background

An Organic Light Emitting Diode (OLED) is an active light emitting display device, which has advantages of active light emission, being ultrathin, a wide viewing angle, high brightness, high contrast, low power consumption, an extremely high reaction speed, lightness and thinness, ability of being special-shaped, and ability of flexible display, and it has gradually become a next generation display technology with great development prospects. An Active Matrix (AM) type OLED is a current-driven device, each sub-pixel is controlled by using an independent Thin Film Transistor (TFT), and each sub-pixel may be continuously and independently driven to emit light.

With continuous development of display technologies, an OLED technology is increasingly applied in transparent display. Transparent display is an important personalized display field of the display technologies, which refers to implement image display in a transparent state, a viewer may see not only an image in a display device, but also a scene behind the display device, and Virtual Reality (VR), Augmented Reality (AR), and a 3D display function may be achieved. In a transparent display device using the OLED technology, each sub-pixel is generally divided into a display region and a light-transmitting region. The display region is provided with a pixel driving circuit and a light-emitting device to achieve image display, and the light-transmitting region is to achieve light transmission.

### Summary

The following is a summary of subject matters described herein in detail. This summary is not intended to limit the protection scope of claims.

An embodiment of the present disclosure provides a display substrate including a plurality of repeating units arranged regularly, a repeating unit includes a display region and a light-transmitting region located in at least one side of the display region, the display region is configured to perform image display, and the light-transmitting region is configured to transmit light; the display region includes a plurality of sub-pixels forming at least two pixel rows and two pixel columns, a sub-pixel includes a pixel driving circuit; the pixel driving circuit includes a first transistor, a second transistor, a third transistor and a storage capacitor, a first electrode of the first transistor is connected with a data signal line, a second electrode of the first transistor is connected with a gate electrode of the second transistor and a first terminal of the storage capacitor respectively, a first electrode of the second transistor is connected with a first power supply line, a second electrode of the second transistor is connected with a second electrode of the third transistor and a second terminal of the storage capacitor respectively, a first electrode of the third transistor is connected with a compensation signal line, and in the pixel driving circuit of at least one sub-pixel, a gate electrode of the first transistor and a gate electrode of the third transistor are connected with a same scanning signal line.

In an exemplary implementation, in a plurality of pixel driving circuits of at least one pixel row, gate electrodes of a plurality of first transistors and gate electrodes of a plurality of third transistors are connected with a same scanning signal line.

In an exemplary implementation, in a plurality of pixel driving circuits of at least one repeating unit, gate electrodes of a plurality of first transistors and gate electrodes of a plurality of third transistors are connected with a same scanning signal line.

In an exemplary implementation, in at least one repeating unit, the scanning signal line extends from the display region to the light-transmitting region, the scanning signal line includes a single-line segment of a single-line structure and a double-line segment of a double-line structure, the single-line segment is disposed in the light-transmitting region, the double-line segment is disposed in the display region, and the double-line segment is respectively connected with pixel driving circuits of a plurality of sub-pixels in the repeating unit.

In an exemplary implementation, the double-line segment includes a first sub-line and a second sub-line, the first sub-line and the second sub-line extend along a pixel row direction, the first sub-line and the second sub-line are arranged along a pixel column direction, the first sub-line is respectively connected with pixel driving circuits of a plurality of sub-pixels in one pixel row, and the second sub-line is respectively connected with pixel driving circuits of a plurality of sub-pixels in another adjacent pixel row.

In an exemplary implementation, the double-line segment further includes a first connection line and a second connection line, the first connection line is connected with one terminal of the first sub-line and the second sub-line, respectively, and the second connection line is connected with the other terminal of the first sub-line and the second sub-line, respectively, and the first connection line, the first sub-line, the second connection line, and the second sub-line constitute a ring-shaped structure.

In an exemplary implementation, the single-line segment is located in an extension direction of the first sub-line or the second sub-line.

In an exemplary implementation, the first connection line is connected with a single-line segment located in the light-transmitting region on one side of the display region in the pixel row direction, and the second connection line is connected with a single-line segment located in the light-transmitting region on the other side of the display region in a direction opposite to the pixel row direction.

In an exemplary implementation, in at least one repeating unit, the single-line segment and the double-line segment are of an integral structure connected with each other.

In an exemplary implementation, orthographic projections of the first power supply line, the data signal line, and the compensation signal line on the display substrate plane at least partially overlap with an orthographic projection of the ring-shaped structure on the display substrate plane.

In an exemplary implementation, in at least one repeating unit, active layers of the third transistors of two sub-pixels in adjacent pixel rows are interconnected as an integral structure, and orthographic projections of the active layers of the third transistors on the plane of the display substrate at least partially overlap with an orthographic projection of the ring-shaped structure on the plane of the display substrate.

In an exemplary implementation, in at least one repeating unit, a plurality of sub-pixels are mirror-symmetrical with respect to the scanning signal line.

In an exemplary implementation, the first terminal of the storage capacitor includes a first electrode plate and a third electrode plate, the second terminal of the storage capacitor includes a second electrode plate, an orthographic projection of the second electrode plate on the display substrate plane at least partially overlaps with an orthographic projection of the first electrode plate on the display substrate plane, the first electrode plate and the second electrode plate form a first capacitor, an orthographic projection of the second electrode plate on the display substrate plane at least partially overlaps with an orthographic projection of the third electrode plate on the display substrate plane, the third electrode plate and the second electrode plate form a second capacitor, the first electrode plate is respectively connected with the third electrode plate, the second electrode of the first transistor and the gate electrode of the second transistor, the second electrode plate is respectively connected with the second electrode of the second transistor and the second electrode of the third transistor, and the first capacitor and the second capacitor constitute a storage capacitor with a parallel structure.

In an exemplary implementation, in a direction perpendicular to the display substrate, the display region includes a drive circuit layer disposed on a base substrate and a light-emitting structure layer disposed on a side of the drive circuit layer away from the base substrate, the drive circuit layer includes at least a first conductive layer, a second conductive layer, and a third conductive layer disposed sequentially along a direction away from the base substrate, the first electrode plate is disposed in the first conductive layer, the second electrode plate is disposed in the second conductive layer, the third electrode plate is disposed in the third conductive layer, and the third electrode plate is connected with the first electrode plate through a via; the at least one repeating unit further includes an electrode plate connection electrode, the electrode plate connection electrode is disposed in the light-transmitting region, and the electrode plate connection electrode is connected with the first electrode plate.

In an exemplary implementation, in at least one repeating unit, the electrode plate connection electrode and the first electrode plate are interconnected as an integral structure.

In an exemplary implementation, the light-emitting structure layer at least includes a fourth conductive layer disposed on a side of the third conductive layer away from the base substrate, and the fourth conductive layer includes at least a first anode and an anode connection electrode, the first anode is disposed in a plurality of sub-pixels of the display region, the anode connection electrode is disposed in the light-transmitting region, the anode connection electrode is connected with the electrode plate connection electrode through an anode via, and the anode via is disposed in the light-transmitting region; in at least one sub-pixel, the first anode includes a first sub-anode and a second sub-anode disposed in isolation, a first terminal of the anode connection electrode is connected with the first sub-anode, and a second terminal of the anode connection electrode is connected with the second sub-anode.

In an exemplary implementation, the third conductive layer further includes a second power supply line and a first auxiliary electrode, the second power supply line is disposed in the display region, the first auxiliary electrode is disposed in the light-transmitting region, and the first auxiliary electrode is connected with the second power supply line.

In an exemplary implementation, in at least one repeating unit, the first auxiliary electrode and the second power supply line are interconnected as an integral structure.

In an exemplary implementation, an orthographic projection of the second power supply line on the display substrate plane at least partially overlaps with an orthographic projection of the ring-shaped structure of the scanning signal line on the display substrate plane.

An embodiment of the present disclosure further provides a display device, including the display substrate described above.

An embodiment of the present disclosure further provides a manufacturing method of a display substrate, the display substrate includes a plurality of repeating units arranged regularly, the repeating units include a display region and a light-transmitting region located in at least one side of the display region, the display region is configured to perform image display, and the light-transmitting region is configured to transmit light; the display region includes a plurality of sub-pixels forming at least two pixel rows and two pixel columns, the sub-pixels include a pixel driving circuit; the manufacturing method includes:
forming a pixel driving circuit in the sub-pixels; the pixel driving circuit includes a first transistor, a second transistor, a third transistor and a storage capacitor, a first electrode of the first transistor is connected with a data signal line, a second electrode of the first transistor is connected with a gate electrode of the second transistor and a first terminal of the storage capacitor, a first electrode of the second transistor is connected with a first power supply line, a second electrode of the second transistor is connected with a second electrode of the third transistor and a second terminal of the storage capacitor respectively, a first electrode of the third transistor is connected with a compensation signal line, and a gate electrode of the first transistor and a gate electrode of the third transistor are connected with a same scanning signal line.

Of course, any product or method for implementing the present invention does not need to achieve all the advantages mentioned above at the same time. Other features and advantages of the present invention will be set forth in the following embodiments of the description, and in part will become apparent from the embodiments of the description, or be learned by practice of the present invention. Purposes and other advantages of the technical solutions of the present disclosure may be achieved and acquired by structures specified in the detailed description, claims and drawings.

Other aspects may be comprehended upon reading and understanding drawings and detailed description.

### Brief Description of Drawings

Accompanying drawings are used to provide understanding of technical solutions of the present disclosure, and form a part of the specification. The accompanying drawings and embodiments of the present disclosure are adopted to explain the technical solutions of the present disclosure, and do not form limitations on the technical solutions of the present disclosure.
FIG. 1 is a schematic diagram of a structure of a display device.
FIG. 2 is a schematic diagram of a planar structure of a display substrate.
FIG. 3 is a schematic diagram of an arrangement of sub-pixels in a display substrate according to an exemplary embodiment of the present disclosure.
FIG. 4 is a schematic diagram of a structure of a display substrate according to an exemplary embodiment of the present disclosure.
FIG. 5 is an equivalent circuit diagram of a pixel driving circuit in a display unit according to an exemplary embodiment of the present disclosure.
FIG. 6 is a schematic diagram of a structure of a scanning signal line according to an exemplary embodiment of the present disclosure;
FIG. 7 is a schematic diagram obtained after a pattern of a first conductive layer is formed according to an embodiment of the present disclosure.
FIGs. 8A and 8B are schematic diagrams after forming a pattern of a semiconductor layer according to an embodiment of the present disclosure.
FIGs. 9A and 9B are schematic diagrams after a pattern of a second conductive layer is formed according to an embodiment of the present disclosure.
FIG.10 is a schematic diagram after a third insulation layer pattern is formed according to an embodiment of the present disclosure.
FIGs.11A and 11B are schematic diagrams after a third conductive layer pattern is formed according to an embodiment of the present disclosure.
FIG. 12 is a schematic diagram after a fourth insulation layer and a first planarization layer pattern are formed according to an embodiment of the present disclosure.
FIGs. 13A and 13B are schematic diagrams after a pattern of a fourth conductive layer is formed according to an embodiment of the present disclosure.
FIGs.14A and 14B are schematic diagrams after a fifth conductive layer pattern is formed according to an embodiment of the present disclosure.
FIG. 15 is a schematic diagram after a pattern of a pixel definition layer is formed according to an embodiment of the present disclosure.
FIG. 16 is a schematic diagram of short circuit defect repair of a display substrate according to an exemplary embodiment of the present disclosure.

Reference signs are described as follows.

| | | | | | |
|---|---|---|---|---|---|
| 11- | first electrode plate; | 12- | electrode plate connection electrode; | 13- | compensation connection line; |
| 21- | First active layer; | 22- | Second active layer; | 23- | Third active layer; |
| 31- | scanning signal line; | 31-1- | double-line segment; | 31-2- | single-line segment; |
| 32- | second electrode plate; | 33- | second gate electrode; | 34- | power supply connection electrode; |
| 35- | power supply auxiliary line; | 36- | second power supply auxiliary line; | 37- | power supply connection line; |
| 38- | electrode connection line; | 41- | First connection electrode; | 42- | Second connection electrode; |
| 43- | Third connection electrode; | 44- | fourth connection electrode; | 45- | fifth connection electrode; |
| 46- | sixth connection electrode; | 47- | third electrode plate; | 51- | First power supply line; |
| 52- | second power supply line; | 53- | Data signal line; | 54- | compensation signal line; |
| 55- | auxiliary electrode line; | 52- | first auxiliary electrode; | 61- | first anode; |
| 61-1- | first sub-anode; | 61-2- | second sub-anode; | 62- | anode connection electrode; |
| 72- | second anode; | 72-1- | third sub-anode; | 72-1- | fourth sub-anode; |
| 73- | third auxiliary electrode; | 80- | repeating unit; | 100- | repeating unit; |
| 110- | display region; | 120- | light-transmitting region; | 200- | short circuit point; |
| 300- | cutoff point. | | | | |

### Detailed Description

To make objectives, technical solutions, and advantages of the present disclosure clearer, the embodiments of the present disclosure will be described in detail below with reference to the accompanying drawings. It is to be noted that implementations may be implemented in multiple different forms. Those of ordinary skills in the art may easily understand such a fact that modes and contents may be transformed into various forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict.

Scales of the drawings in the present disclosure may be used as a reference in actual processes, but are not limited thereto. For example, a width-length ratio of a channel, a thickness and spacing of each film layer, and a width and spacing of each signal line may be adjusted according to actual needs. A quantity of pixels in a display substrate and a quantity of sub-pixels in each pixel are not limited to numbers shown in the drawings. The drawings described in the present disclosure are schematic structural diagrams only, and one mode of the present disclosure is not limited to shapes, numerical values, or the like shown in the drawings.

Ordinal numerals "first", "second", "third", etc., in the specification are set not to form limits in numbers but only to avoid confusion between constituent elements.

In the specification, for convenience, expressions "central", "above", "below", "front", "back", "vertical", "horizontal", "top", "bottom", "inside", "outside", etc., for indicating directional or positional relationships are used to illustrate positional relationships between the constituent elements with reference to the accompanying drawings, not to indicate or imply that involved devices or elements are required to have specific orientations or are structured and operated in the specific orientations but only to easily describe the present specification and simplify the description, and thus should not be understood as limitations on the present disclosure. The positional relationships between the constituent elements may be changed as appropriate based on a direction according to which each constituent element is described. Therefore, appropriate replacements based on situations are allowed, which is not limited to the expressions in the specification.

In the specification, unless otherwise explicitly specified and defined, terms "mounting", "coupling", and "connection" should be understood in a broad sense. For example, it may be a fixed connection, or a detachable connection, or an integral connection; it may be a mechanical connection or an electrical connection; it may be a direct connection, or an indirect connection through a middleware, or an internal communication between two elements. Those of ordinary skills in the art may understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. It is to be noted that in the specification, the channel region refers to a region through which a current mainly flows.

In the specification, a first electrode may be a drain electrode, and a second electrode may be a source electrode. Or, the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode", as well as a "source terminal" and a "drain terminal", are interchangeable in the specification.

In the specification, an "electrical connection" includes a case that constituent elements are connected with together through an element with a certain electrical action. The "element with a certain electrical effect" is not particularly limited as long as electrical signals between the connected constituent elements may be sent and received. Examples of the "element with a certain electrical action" not only include an electrode and a wiring, but also include a switching element such as a transistor, a resistor, an inductor, a capacitor, another element with various functions, etc.

In the specification, "parallel" refers to a state in which an angle formed by two straight lines is above -10° and below 10°, and thus may include a state in which the angle is above -5° and below 5°. In addition, "perpendicular" refers to a state in which an angle formed by two straight lines is above 80° and below 100°, and thus may include a state in which the angle is above 85° and below 95°.

In the specification, a "film" and a "layer" are interchangeable. For example, a "conductive layer" may be replaced with a "conductive film" sometimes. Similarly, an "insulation film" may be replaced with an "insulation layer" sometimes.

A triangle, rectangle, trapezoid, pentagon, or hexagon, etc. in the specification is not strictly defined, and it may be an approximate triangle, rectangle, trapezoid, pentagon, or hexagon, etc. There may be some small deformations caused by tolerance, and there may be a chamfer, an arc edge, deformation, etc.

In the present disclosure, "about" means that a boundary is not defined so strictly and numerical values within process and measurement error ranges are allowed.

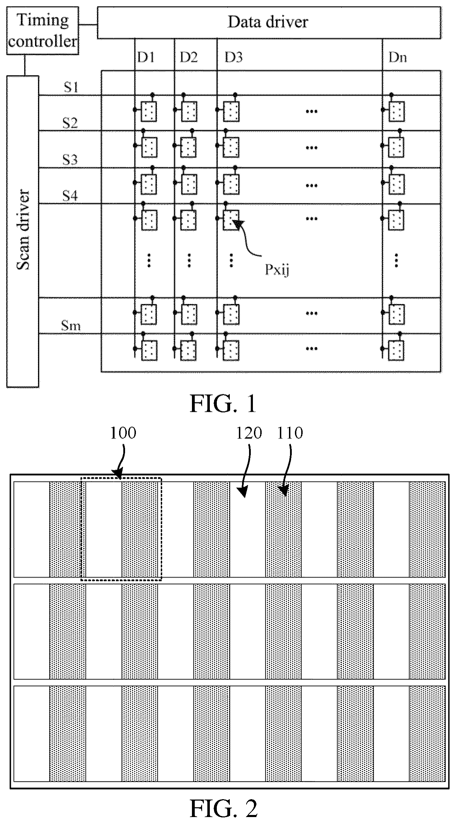

FIG. 1 is a schematic diagram of a structure of a display device. As shown in FIG. 1, an OLED display device may include a timing controller, a data driver, a scan driver, and a pixel array. The timing controller is connected with the data driver and the scan driver respectively, the data driver is connected with a plurality of data signal lines (D1 to Dn) respectively, and the scan driver is connected with a plurality of scanning signal lines (S1 to Sm) respectively. The sub-pixel array may include a plurality of sub-pixels Pxij. Each sub-pixel Pxij may be connected with a corresponding data signal line and a corresponding scanning signal line, wherein i and j may be natural numbers. At least one sub-pixel Pxij may include at least a circuit unit and a display unit. The circuit unit may include at least a pixel driving circuit connected with a scanning signal line and a data signal line, respectively. The display unit may include at least a light-emitting device connected with the pixel driving circuit of the circuit unit, and the sub-pixel PXij may refer to a sub-pixel in which a pixel driving circuit is connected with an i-th scanning signal line and a j-th data signal line. In an exemplary implementation, the timing controller may provide a control signal and a gray scale value suitable for the specification of the data driver to the data driver, and may provide a scan start signal, a clock signal suitable for the specification of the scan driver and the like to the scan driver. The data driver may generate data voltages to be provided to the data signal lines 531, D2, D3, ..., and Dn using the grayscale value and the control signal that are received from the timing controller. For example, the data driver may sample the grayscale value using the clock signal and apply a data voltage corresponding to the grayscale value to the data signal lines 531 to Dn by taking a pixel row as a unit, wherein n may be a natural number. The scan driver may generate a scan signals to be provided to the scanning signal lines S1, S2, S3, ..., and Sm by receiving the clock signal and the scan start signal from the timing controller. For example, the scan driver may sequentially provide a scan signal with an on-level pulse to the scanning signal lines S1 to Sm. For example, the scan driver may be constructed in a form of a shift register and generate a scan signal in a manner of sequentially transmitting scan start signals provided in a form of an on-level pulse to a next-stage circuit under control of the clock signal, wherein m may be a natural number. In an exemplary implementation, the pixel array may be arranged on a display substrate.

FIG.2 is a schematic diagram of a planar structure of a display substrate. As shown in FIG. 2, in an exemplary implementation, the display substrate may include multiple repeating units 100 arranged regularly, and at least one repeating unit 100 may include a display region 110 and a light-transmitting region 120. The display region 110 may include multiple sub-pixels, and at least one sub-pixel may include a circuit unit and a light-emitting unit. The circuit unit may at least include a pixel driving circuit, and the light-emitting unit may at least include a light-emitting device, the light-emitting device of the light-emitting unit is connected with a pixel driving circuit of a corresponding circuit unit. The display region 110 is configured to perform image display. The light-transmitting region 120 may be located in at least one side of the display region 110 in the repeating unit 100, the light-transmitting region 120 is configured to transmit light, so that the repeating unit 100 may achieve image display in a transparent state, i.e., transparent display. In an exemplary implementation, the repeating units are basic units constituting the display substrate, and the display substrate is constructed by repeating and continuously disposing the repeating units along at least one direction, i.e., the display substrate is formed by splicing a plurality of repeating units.

At present, existing transparent display devices have problems such as low resolution and low transparency. In addition, transparent display devices using OLED technology, especially large-size transparent display devices, have high requirements for signal line defects and pixel-level yield, and the signal line defects that occur need to be repaired. According to the research of the inventors of the present application, since the existing repair treatment can only repair the signal line at some positions, and cannot make all signal lines repairable, so the repair success rate is low, and the product yield rate is reduced.

An exemplary embodiment of the present disclosure provides a display substrate including a plurality of repeating units arranged regularly, the repeating units include a display region and a light-transmitting region located in at least one side of the display region, the display region is configured to perform image display, and the light-transmitting region is configured to transmit light; the display region includes a plurality of sub-pixels forming at least two pixel rows and two pixel columns, the sub-pixels include a pixel driving circuit; the pixel driving circuit includes a first transistor, a second transistor, a third transistor and a storage capacitor, wherein a first electrode of the first transistor is connected with a data signal line, a second electrode of the first transistor is connected with a gate electrode of the second transistor and a first terminal of the storage capacitor respectively, a first electrode of the second transistor is connected with a first power supply line, a second electrode of the second transistor is connected with a second electrode of the third transistor and a second terminal of the storage capacitor respectively, a first electrode of the third transistor is connected with a compensation signal line, and in the pixel driving circuit of at least one sub-pixel, a gate electrode of the first transistor and a gate electrode of the third transistor are connected with a same scanning signal line.

In an exemplary implementation, in a plurality of pixel driving circuits of at least one pixel row, gate electrodes of a plurality of first transistors and gate electrodes of a plurality of third transistors are connected with a same scanning signal line.

In an exemplary implementation, in a plurality of pixel driving circuits of at least one repeating unit, gate electrodes of a plurality of first transistors and gate electrodes of a plurality of third transistors are connected with a same scanning signal line.

In an exemplary implementation, in at least one repeating unit, the scanning signal line extends from the display region to the light-transmitting region, the scanning signal line includes a single-line segment of a single-line structure and a double-line segment of a double-line structure, the single-line segment is disposed in the light-transmitting region, the double-line segment is disposed in the display region, and the double-line segment is respectively connected with pixel driving circuits of a plurality of sub-pixels in the repeating unit.

In an exemplary implementation, in at least one repeating unit, a plurality of sub-pixels are mirror-symmetrical with respect to the scanning signal line.

The display substrate in the present disclosure is illustrated with examples below through some exemplary embodiments.

In an exemplary implementation, in a direction parallel to the display substrate, the display substrate may include multiple repeating units arranged regularly, and at least one repeating unit may include a display region 110 and a light-transmitting region 120, the display region 110 is configured to perform image display, and the light-transmitting region 120 is configured to perform light transmission, thereby achieving transparent display. In a direction perpendicular to the display substrate, the display substrate may at least include a drive circuit layer disposed on the base substrate and a light-emitting structure layer disposed on a side of the drive circuit layer away from the base substrate. In at least one repeating unit, the drive circuit layer of the display region 110 may include multiple circuit units, the light-emitting structure layer of the display region 110 may include a plurality of light-emitting units, the circuit units may at least include a pixel driving circuit, and a light-emitting unit may at least include a light-emitting device, the light-emitting device is connected with a pixel driving circuit of a corresponding circuit unit.

In an exemplary implementation, circuit units mentioned in the present disclosure refer to regions divided according to pixel driving circuits, and light-emitting units mentioned in the present disclosure refer to regions divided according to light-emitting devices. In an exemplary implementation, a position of an orthographic projection of a light-emitting unit on the base substrate may correspond to a position of an orthographic projection of a circuit unit on the substrate, or a position of an orthographic projection of a light-emitting unit on the base substrate may not correspond to a position of an orthographic projection of a circuit unit on the base substrate.

In an exemplary embodiment of the present disclosure, a position of an orthographic projection of a circuit unit on the base substrate is in one-to-one correspondence with a position of an orthographic projection of a light-emitting unit on the base substrate, and the circuit unit and the light-emitting unit constitute a sub-pixel. Therefore, sub-pixels are uniformly used to refer to circuit units and light-emitting units in following contents.

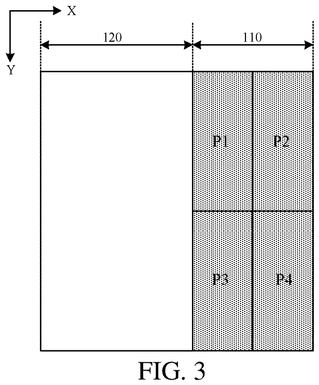

FIG. 3 is a schematic diagram of an arrangement of sub-pixels in a display substrate according to an exemplary embodiment of the present disclosure, illustrating a structure of a repeating unit. As shown in FIG. 3, the repeating unit may include a display region 110 and a light-transmitting region 120, and the display region 110 may be located in a side of the light-transmitting region 120 in a first direction X. In an exemplary implementation, the display region 110 may include four sub-pixels, i.e., a first sub-pixel P1, a second sub-pixel P2, a third sub-pixel P3, and a fourth sub-pixel P4, respectively, and the four sub-pixels are arranged in a square manner, such that an aperture ratio and an area of the light-transmitting region may be effectively increased.

In an exemplary implementation, the second sub-pixel P2 may be disposed on a side of the first sub-pixel P1 in the first direction X, the third sub-pixel P3 may be disposed on a side of the first sub-pixel P1 in a second direction Y, and the fourth sub-pixel P4 may be disposed on a side of the third sub-pixel P3 in the first direction X. Multiple sub-pixels sequentially disposed along the first direction X may be referred to as a pixel row, and multiple sub-pixels sequentially disposed along the second direction Y may be referred to as a pixel column, and the first direction X intersects with the second direction Y.

In an exemplary implementation, the first sub-pixel P1 may be a red sub-pixel (R) emitting red light, the second sub-pixel P2 may be a blue sub-pixel (B) emitting blue light, the third sub-pixel P3 may be a white sub-pixel (W) emitting white light, and the fourth sub-pixel P4 may be a green sub-pixel (G) emitting green light. In some possible implementations, an arrangement mode of RGBW may be adjusted according to actual needs, and the present disclosure is not specifically limited thereto.

In an exemplary implementation, each sub-pixel may include a circuit unit and a light-emitting unit provided on a side of the circuit unit away from the base substrate, the circuit unit may include at least a pixel driving circuit, the light-emitting unit may include at least a light-emitting device, and the light-emitting device of the light-emitting unit is connected with the pixel driving circuit of the corresponding circuit unit.

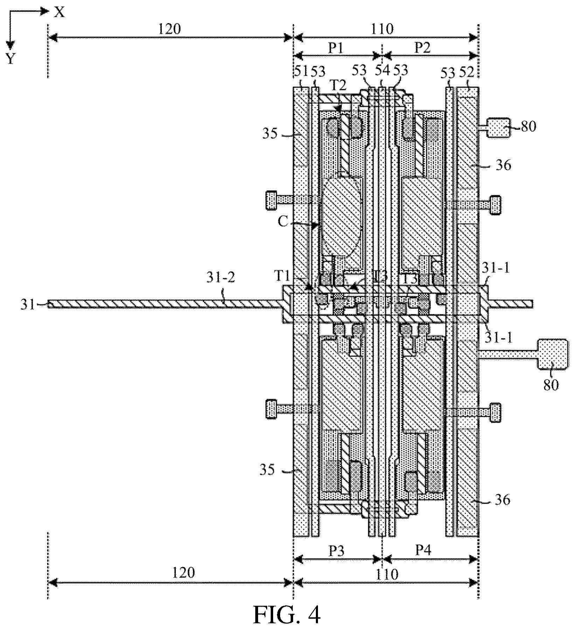

FIG. 4 is a schematic diagram of a structure of a display substrate according to an exemplary embodiment of the present disclosure, and schematically illustrates a structure of a pixel driving circuit in a repeating unit. As illustrated in FIG. 4, the repeating unit may include a display region 110 and a light-transmitting region 120, the display region 110 may include a first sub-pixel P1, a second sub-pixel P2, a third sub-pixel P3, and a fourth sub-pixel P4 arranged in a square manner, and at least one sub-pixel may include a pixel driving circuit and a light-emitting device.

In an exemplary implementation, at least one repeating unit may include one scanning signal line 31, one first power supply line 51, one second power supply line 52, four data signal lines 53, and one compensation signal line 54. In an exemplary implementation, the scanning signal line 31 may be disposed in the display region 110 and the light-transmitting region 120, and the first power supply line 51, the second power supply line 52, the data signal line 53, and the compensation signal line 54 may be disposed in the display region 110.

In an exemplary implementation, the at least one pixel driving circuit at least includes a first transistor T1 as a data writing transistor, a second transistor T2 as a drive transistor, a third transistor T3 as a sensing transistor, and a storage capacitor C.

In an exemplary implementation, in at least one sub-pixel, a gate electrode of the first transistor T1 and a gate electrode of the third transistor T3 are connected with a same scanning signal line 31.

In an exemplary implementation, in at least one pixel row, gate electrodes of two first transistors T1 and gate electrodes of two third transistors T3 are connected with a same scanning signal line 31.

In an exemplary implementation, in at least one repeating unit, gate electrodes of four first transistors T1 and gate electrodes of four third transistors T3 are connected with a same scanning signal line 31.

In an exemplary implementation, a shape of the scanning signal line 31 may be a line shape in which a main body portion extends along the first direction X, the scanning signal line 31 may be disposed in a middle region of the repeating unit in the second direction Y, and a plurality of sub-pixels in the repeating unit may be mirror-symmetrical with respect to the scanning signal line 31.

In an exemplary implementation, shapes of the first power supply line 51, the second power supply line 52, the data signal line 53, and the compensation signal line 54 may be a line shape in which a main body portion extends along the second direction Y, and one first power supply line 51, two data signal lines 53, one compensation signal line 54, two data signal lines 53, and one second power supply line 52 may be sequentially provided along the first direction X. In at least one repeating unit, the first power supply line 51 may be located in one side of the display region 110 in the first direction X, the second power supply line 52 may be located in the other side of the display region 110 in the first direction X, the compensation signal line 54 may be located between the first power supply line 51 and the second power supply line 52, two of the four data signal lines 53 may be located between the first power supply line 51 and the compensation signal line 54, and the other two of the four data signal lines 53 may be located between the second power supply line 52 and the compensation signal line 54.

In an exemplary implementation, positions of the first power supply line 51 and the second power supply line 52 may be substantially mirror-symmetrical with respect to the compensation signal line 54, and two data signal lines 53 located in a side of the compensation signal line 54 in an opposite direction of the first direction X and two data signal lines 53 located in a side of the compensation signal line 54 in the first direction X may be substantially mirror-symmetrical with respect to the compensation signal line 54.

In an exemplary implementation, one scanning signal line 31 may define two adjacent pixel rows, one side of the scanning signal line 31 in the opposite direction of the second direction Y defines a first pixel row, and one side of the scanning signal line 31 in the second direction Y defines a second pixel row. The first power supply line 51, the compensation signal line 54, and the second power supply line 52 may define two pixel columns, the first power supply line 51 and the compensation signal line 54 may define a first pixel column, and the second power supply line 52 and the compensation signal line 54 may define a second pixel column. Thus, the scanning signal line 31, the first power supply line 51, the second power supply line 52, and the compensation signal line 54 define four sub-pixels.

In an exemplary implementation, a sub-pixel located at a position of the first pixel row and the first pixel column (i.e. upper left of the display unit) may be referred to as a first sub-pixel P1, a sub-pixel located at a position of the first pixel row and the second pixel column (i.e. upper right of the display unit) may be referred to as a second sub-pixel P2, a sub-pixel located at a position of the second pixel row and the first pixel column (i.e. lower left of the display unit) may be referred to as a third sub-pixel P3, and a sub-pixel located at a position of the second pixel row and the second pixel column (i.e. lower right of the display unit) may be referred to as a fourth sub-pixel P4.

In an exemplary implementation, a pixel driving circuit structure in the first pixel column and a pixel driving circuit structure in the second pixel column may be substantially mirror-symmetrical with respect to the compensation signal line 54, that is, a pixel driving circuit structure in the first sub-pixel P1 and a pixel driving circuit structure in the second sub-pixel P2 may be substantially mirror-symmetrical with respect to the compensation signal line 54, and a pixel driving circuit structure in the third sub-pixel P3 and a pixel driving circuit structure in the fourth sub-pixel P4 may be substantially mirror-symmetrical with respect to the compensation signal line 54.

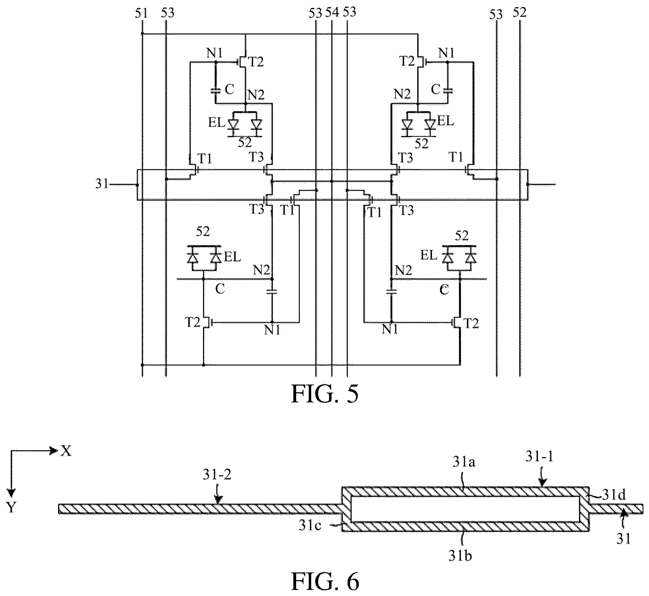

FIG. 5 is an equivalent circuit diagram of a pixel driving circuit in a display unit according to an exemplary embodiment of the present disclosure. As shown in FIG. 5, at least one display unit may include four pixel driving circuits, the four pixel driving circuits may be arranged in a square manner, and the pixel driving circuits may be of a 3T1C structure.

In an exemplary implementation, at least one pixel driving circuit may include three transistors (a first transistor T1, a second transistor T2, and a third transistor T3) and one storage capacitor C. The pixel driving circuit is connected with a scanning signal line 31, a first power supply line 51, a data signal line 53, and a compensation signal line 54, respectively.

In an exemplary implementation, the pixel driving circuit may include a first node N1 and a second node N2. The first node N1 is connected with a second electrode of the first transistor T1, a gate electrode of the second transistor T2 and a first terminal of the storage capacitor C, respectively, and the second node N2 is connected with a second electrode of the second transistor T2, a second electrode of the third transistor T3 and a second terminal of the storage capacitor C, respectively.

In an exemplary implementation, the first terminal of the storage capacitor C is connected with the first node N1, the second terminal of the storage capacitor C is connected with the second node N2, and the storage capacitor C is configured to store a potential of the gate electrode of the second transistor T2.

In an exemplary implementation, a gate electrode of the first transistor T1 is connected with the scanning signal line 31, a first electrode of the first transistor T1 is connected with the data signal line 53, and a second electrode of the first transistor T1 is connected with the first node N1. When a turned-on signal is applied to the scanning signal line 31, the first transistor T1 inputs a data signal of the data signal line 53 to the gate electrode of the second transistor T2.

In an exemplary implementation, the gate electrode of the second transistor T2 is connected with the first node N1, a first electrode of the second transistor T2 is connected with the first power supply line 51, and the second electrode of the second transistor T2 is connected with the second node N2. The second transistor T2 generates a corresponding current at the second electrode of the second transistor T2 under control of a data signal received by the gate electrode of the second transistor T2.

In an exemplary implementation, a gate electrode of the third transistor T3 is connected with the scanning signal line 31, a first electrode of the third transistor T3 is connected with the compensation signal line 54, and a second electrode of the third transistor T3 is connected with the second node N2. When a turned-on signal is applied to the scanning signal line 31, the third transistor T3 extracts a threshold voltage Vth and a migration rate of the second transistor T2 in response to a compensation timing, to compensate the threshold voltage Vth.

In an exemplary implementation, in a pixel driving circuit of at least one sub-pixel, a gate electrode of a first transistor T1 and a gate electrode of a third transistor T3 are connected with a same scanning signal line 31.

In an exemplary implementation, in two pixel driving circuits of at least one pixel row, gate electrodes of two first transistors T1 and gate electrodes of two third transistors T3 are connected with a same scanning signal line 31.

In an exemplary implementation, in four pixel driving circuits of at least one repeating unit, gate electrodes of four first transistors T1 and gate electrodes of four third transistors T3 are connected with a same scanning signal line 31.

In an exemplary implementation, the light-emitting device EL may be an OLED including a first electrode (anode), an organic light emitting layer, and a second electrode (cathode), which are stacked, or may be a QLED including a first electrode (anode), a quantum dot light emitting layer, and a second electrode (cathode), which are stacked. The first electrode of the light-emitting device EL is connected with the second node N2, the second electrode of the light-emitting device EL is connected with the second power supply line 52, and the light-emitting device EL emits light with corresponding brightness in response to a current of the second electrode of the second transistor T2.

In an exemplary implementation, a signal of the first power supply line 51 is a continuously supplied high-level signal, and a signal of the second power supply line 52 is a continuously supplied low-level signal.

In an exemplary implementation, the first transistor T1 to the third transistor T3 may be P-type transistors, or may be N-type transistors. Use of a same type of transistors in a pixel driving circuit may simplify a process flow, reduce a process difficulty of a display panel, and improve a product yield. In some possible Implementations, the first transistor T1 to the third transistor T3 may include a P-type transistor and an N-type transistor.

In an exemplary implementation, for the first transistor T1 to the third transistors T3, low temperature poly silicon thin film transistors may be used, oxide thin film transistors may be used, or a low temperature poly silicon thin film transistor and an oxide thin film transistor may be used. An active layer of a low temperature poly silicon thin film transistor is made of Low Temperature Poly silicon (LTPS for short), and an active layer of an oxide thin film transistor is made of an oxide semiconductor (Oxide). The low temperature poly silicon thin film transistor has advantages, such as a high mobility and fast charging, and the oxide thin film transistor has advantages, such a low leakage current. The low temperature poly silicon thin film transistor and the oxide thin film transistor are integrated on one display substrate, that is, an LTPS + Oxide (LTPO for short) display substrate, so that advantages of the low temperature poly silicon thin film transistor and the oxide thin film transistor may be utilized, low-frequency drive may be achieved, power consumption may be reduced, and display quality may be improved.

As shown in FIGs. 4 and 5, in the exemplary implementation, a shape of the scanning signal line 31 may be a line shape in which a main body portion extends along the first direction X, and the scanning signal line 31 may be disposed in the display region 110 and the light-transmitting region 120. In the first direction X, the scanning signal line 31 may extend from the display region 110 to the light-transmitting region 120, or the scanning signal line 31 may extend from the light-transmitting region 120 to the display region 110. In the second direction Y, the scanning signal line 31 may be disposed in a middle region of the repeating unit in the second direction Y, located between the first sub-pixel P1 and the third sub-pixel P3, and between the second sub-pixel P2 and the fourth sub-pixel P4. With respect to the scanning signal line 31, the plurality of sub-pixels in the repeating unit may be mirror-symmetrical with respect to the scanning signal line 31, that is, the first sub-pixel P1 and the third sub-pixel P3 may be substantially mirror-symmetrical with respect to the scanning signal line 31, and the second sub-pixel P2 and the fourth sub-pixel P4 may be substantially mirror-symmetrical with respect to the scanning signal line 31.

FIG. 6 is a schematic diagram of a structure of a scanning signal line according to an exemplary embodiment of the present disclosure. As shown in FIG. 6, in the exemplary implementation, the scanning signal line 31 may include a double-line segment 31-1 of a double-line structure, and a single-line segment 31-2 of a single-line structure, the double-line segment 31-1 may be located in the display region 110, and the single-line segment 31-2 may be located in the light-transmitting region 120, that is, the display region 110 is provided with two signal lines, the two signal lines respectively connected with pixel driving circuits of a plurality of sub-pixels in the repeating unit, and the light-transmitting region 120 is provided with only one signal line.

In an exemplary implementation, the double-line segment 31-1 of the display region 110 may include a first sub-line 31a and a second sub-line 31b extending along the first direction X (i.e. pixel row direction), the first sub-line 31a and the second sub-line 31b are arranged along the second direction Y (i.e. pixel column direction), and the second sub-line 31b may be disposed on a side of the first sub-line 31a in the second direction Y. The first sub-line 31a may be connected with pixel driving circuits of two sub-pixels in a first pixel row, respectively, and the second sub-line 31b may be connected with pixel driving circuits of two sub-pixels in a second pixel row, respectively, thereby achieving a connection between the double-line segment 31-1 and multiple pixel driving circuits in the repeating unit.

In an exemplary implementation, the first sub-line 31a is connected with gate electrodes of the first transistors T1 and gate electrodes of the third transistors T3 in the first sub-pixel P1 and the second sub-pixel P2, respectively, and the second sub-line 31b is connected with gate electrodes of the first transistors T1 and gate electrodes of the third transistors T3 in the third sub-pixel P3 and the fourth sub-pixel P4, respectively, so that the double-line segment 31-1 can control the ON or OFF of a plurality of first transistors T1 and T3 in the repeating unit.

In an exemplary implementation, the double-line segment 31-1 of the display region 110 may further include a first connection line 31c and a second connection line 31d. The first connection line 31 may be connected with terminals of the first sub-line 31a and the second sub-line 31b in an opposite direction of the first direction X, respectively, and the second connection line 31d may be connected with terminals of the first sub-line 31a and the second sub-line 31b in the first direction X, respectively, so that the first connection line 31c, the first sub-line 31a, the second connection line 31d, and the second sub-line 31b are sequentially connected and constitute a ring-shaped structure.

In an exemplary implementation, the single-line segment 31-2 may be located in an extending direction of the first sub-line 31a or the second sub-line 31b, the first connection line 31c may be connected with the single-line segment 31-2 of the light-transmitting region 120 in the opposite direction of the first direction X of the display region 110, the second connection line 31d may be connected with the single-line segment 31-2 of the light-transmitting region 120 in the first direction X of the display region 110, and the double-line segment 31-1 and the single-line segment 31-2 constitute a continuous scanning signal line 31.

In an exemplary implementation, in at least one repeating unit, the double-line segment 31-1 of the display region 110 and the single-line segment 31-2 of the light-transmitting region 120 may be interconnected as an integral structure.

In an exemplary implementation, in at least one sub-pixel, the gate electrode of the first transistor T1 and the gate electrode of the third transistor T3 are connected with the same scanning signal line 31, the first electrode of the first transistor T1 is connected with the data signal line 53, the second electrode of the first transistor T1 is connected with the gate electrode of the second transistor and the first terminal of the storage capacitor C respectively, the first electrode of the second transistor T2 is connected with the first power supply line 51, the second electrode of the second transistor T2 is connected with the second electrode of the third transistor T3 and the second terminal of the storage capacitor C, and the first electrode of the third transistor T3 is connected with the compensation signal line 54.

In an exemplary implementation, the at least one repeating unit may further include a compensation connection line 13, a shape of the compensation connection line 13 may be a bar shape extending along the first direction X, the compensation connection line 13 may be located between the first pixel row and the second pixel row, and an extension length of the compensation connection line 13 in the first pixel column is substantially the same as an extension length of the compensation connection line 13 in the second pixel column, the compensation connection line 13 in the first pixel column and the compensation connection line 13 in the second pixel column may be substantially mirror-symmetrical with respect to the compensation signal line 54.

In the exemplary implementation, the compensation signal line 54 is connected with the compensation connection line 13 through a via at an overlapping position of the compensation connection line 13 and the compensation signal line 54. A terminal portion of the compensation connection line 13 located in the first pixel column is connected with the first electrode of the third transistor T3 in the first pixel column, and a terminal portion of the compensation connection line 13 located in the second pixel column is connected with the first electrode of the third transistor T3 in the second pixel column, thus realizing a one-to-four structure of the compensation connection line, i.e. one compensation signal line can respectively write compensation signals to four pixel driving circuits in the display unit.

In an exemplary implementation, the at least one repeating unit may further include at least one first power supply auxiliary line 35, an orthographic projection of the first power supply auxiliary line 35 on the base substrate and an orthographic projection of the first power supply line 51 on the base substrate are at least partially overlapped, and the first power supply line 51 is connected with the first power supply auxiliary line 35 through a via to form a double-layer first power supply trace structure.

In an exemplary implementation, the at least one repeating unit may further include at least one second power supply auxiliary line 36, an orthographic projection of the second power supply auxiliary line 36 on the base substrate and an orthographic projection of the second power supply line 52 on the base substrate are at least partially overlapped, and the second power supply line 52 is connected with the second power supply auxiliary line 36 through a via to form a double-layer second power supply trace structure.

In an exemplary implementation, the first terminal of the storage capacitor C may include a first electrode plate and a third electrode plate, and the second terminal of the storage capacitor C may include a second electrode plate. An orthographic projection of the second electrode plate on the base substrate is at least partially overlapped with an orthographic projection of the first electrode plate on the base substrate, the first electrode plate and the second electrode plate form a first capacitor. An orthographic projection of the second electrode plate on the base substrate is at least partially overlapped with an orthographic projection of the third electrode plate on the base substrate, the third electrode plate and the second electrode plate form a second capacitor. The first electrode plate is connected with the third electrode plate, and the first capacitor and the second capacitor form a storage capacitor with a parallel structure.

In an exemplary implementation, in a direction perpendicular to the base substrate, the display region 110 may at least include a drive circuit layer disposed on the base substrate and a light-emitting structure disposed on a side of the drive circuit layer away from the base substrate. The drive circuit layer may include at least a first conductive layer, a second conductive layer, and a third conductive layer sequentially disposed along a direction away from the base substrate, the first electrode plate may be disposed in the first conductive layer, the second electrode plate may be disposed in the second conductive layer, the third electrode plate may be disposed in the third conductive layer, and the third electrode plate is connected with the first electrode plate through a via. The light-emitting structure layer may include at least a fourth conductive layer disposed on a side of the third conductive layer away from the base substrate, a fifth conductive layer disposed on a side of the fourth conductive layer away from the base substrate, and a cathode layer disposed on a side of the fifth conductive layer away from the substrate, the fourth conductive layer may include at least a first anode disposed in a plurality of sub-pixels of the display region 110, and the fifth conductive layer may at least include a second anode disposed in a plurality of sub-pixels of the display region 110.

In an exemplary implementation, in at least one repeating unit, the light-transmitting region 120 may further include at least one auxiliary cathode 80, and the auxiliary cathode 80 are connected with the second power supply line 52. The auxiliary cathode 80 is configured to provide a low-level signal to the cathode while being configured to reduce the diffraction effect of the light-transmitting region.

Exemplary description is made below through a manufacturing process of a display substrate. A "patterning process" mentioned in the present disclosure includes photoresist coating, mask exposure, development, etching, photoresist stripping, and the like for a metal material, an inorganic material, or a transparent conductive material, and includes organic material coating, mask exposure, development, and the like for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a certain material on a base substrate using deposition, coating, or other processes. If the "thin film" does not need to be processed through a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process. "A and B are provided in a same layer" in the present disclosure means that A and B are formed simultaneously through a same patterning process, and a "thickness" of a film layer is a dimension of the film layer in a direction perpendicular to a display substrate. In an exemplary embodiment of the present disclosure, "an orthographic projection of B being within a range of an orthographic projection of A" or "an orthographic projection of A containing an orthographic projection of B" means that a boundary of the orthographic projection of B falls within a range of a boundary of the orthographic projection of A, or the boundary of the orthographic projection of A overlaps with the boundary of the orthographic projection of B.

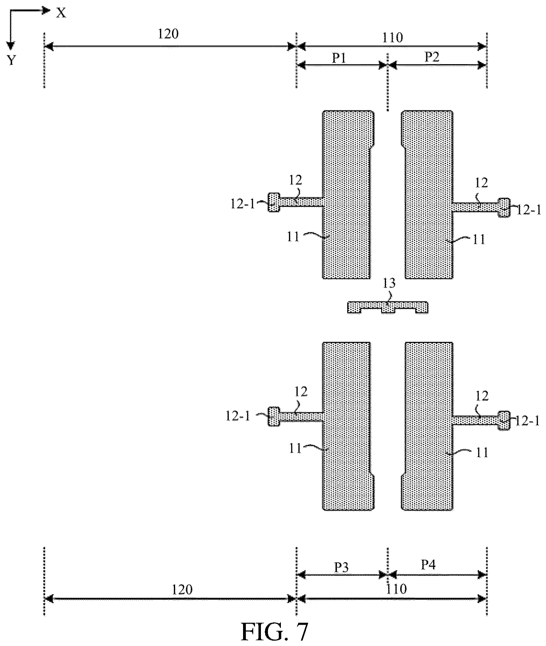

In an exemplary implementation, taking four sub-pixels (a first sub-pixel P1, a second sub-pixel P2, a third sub-pixel P3, and a fourth sub-pixel P4) of a repeating unit as an example, a manufacturing process of a display substrate of an exemplary embodiment of the present disclosure may include following operations.
(1) Forming a pattern of a first conductive layer. In an exemplary implementation, forming the pattern of the first conductive layer includes: depositing a first conductive thin film on a base substrate, patterning the first conductive thin film through a patterning process, to form the pattern of the first conductive layer on the base substrate, as shown in FIG. 7. In an exemplary implementation, the first conductive layer may be referred to as a light Shielding Layer (SHL).

In an exemplary implementation, the first conductive layer of each sub-pixel in the display substrate may at least include a first electrode plate 11 and an electrode plate connection electrode 12.

In an exemplary implementation, the first electrode plate 11 may have a rectangular shape. Corners of the rectangular shape may be provided with chamfers. The first electrode plate 11 may serve as an electrode plate of the storage capacitor. The first electrode plate 11 is configured to form a first capacitor with a second electrode plate to be formed subsequently.

In an exemplary implementation, the first electrode plate 11 is further configured to shield light for a second transistor, reduce an intensity of light irradiated on the second transistor, and reduce a leakage current of the second transistor, thereby reducing an influence of illumination on characteristics of the second transistor.

In an exemplary implementation, a shape of the electrode plate connection electrode 12 may be a strip shape in which a main body portion extends along the first direction X, a first terminal of the electrode plate connection electrode 12 is connected with the first electrode plate 11, a second terminal of the electrode plate connection electrode 12 extends along a direction away from the first electrode plate 11 into an adjacent light-transmitting region 120, and the electrode plate connection electrode 12 is configured to be connected with a subsequently formed sixth connection electrode, and connected with the anode connection electrode through the sixth connection electrode.

In an exemplary implementation, the second terminal of the electrode plate connection electrode 12 may form a rectangular anode connection block 12-1 such that an entirety of the electrode plate connection electrode 12 has a "T" shape, and the anode connection block 12-1 is located in the light-transmitting region 120. The connection block 12-1 is configured to accommodate a subsequently formed eleventh via such that a subsequently formed sixth connection electrode is connected with the electrode plate connection electrode 12 through the via.

In an exemplary implementation, the electrode plate connection electrode 12 in the first sub-pixel P1 may be located in a side of the first electrode plate 11 in the sub-pixel opposite to the first direction X, and the first electrode plate 11 and the electrode plate connection electrode 12 in the first sub-pixel P1 may be of an integral structure connected with each other. The electrode plate connection electrode 12 in the second sub-pixel P2 may be located in a side of the first electrode plate 11 in the sub-pixel in the first direction X, and the first electrode plate 11 and the electrode plate connection electrode 12 in the second sub-pixel P2 may be of an integral structure connected with each other. The electrode plate connection electrode 12 in the third sub-pixel P3 may be located in a side of the first electrode plate 11 in the sub-pixel opposite to the first direction X, and the first electrode plate 11 and the electrode plate connection electrode 12 in the third sub-pixel P3 may be of an integral structure connected with each other. The electrode plate connection electrode 12 in the fourth sub-pixel P4 may be located in a side of the first electrode plate 11 in the sub-pixel in the first direction X, and the first electrode plate 11 and the electrode plate connection electrode 12 in the fourth sub-pixel P4 may be of an integral structure connected with each other.

In an exemplary implementation, the first conductive layer in the at least one repeating unit may further include a compensation connection line 13. A shape of the compensation connection line 13 may be a strip shape in which a main body portion extends along the first direction X, in the first direction X, the compensation connection line 13 may be disposed across the first pixel column and the second pixel column, in the second direction Y, the compensation connection line 13 may be disposed between the first pixel row and the second pixel row. The compensation connection line 13 may be configured to be connected with a subsequently formed compensation signal line on one hand to realize a one-to-four structure of the compensation signal line in one repeating unit, and to be connected with a first region of the third active layer in each sub-pixel through a subsequently formed connection electrode on the other hand, such that the compensation signal line can provide a compensation signal to the third transistor in each sub-pixel.

In an exemplary implementation, a first conductive layer pattern in the first sub-pixel P1 and a first conductive layer pattern in the third sub-pixel P3 may be substantially mirror-symmetrical with respect to a horizontal reference line, and a first conductive layer pattern in the second sub-pixel P2 and a first conductive layer pattern in the fourth sub-pixel P4 may be substantially mirror-symmetrical with respect to the horizontal reference line, The first conductive layer pattern in the first sub-pixel P1 and the first conductive layer pattern in the second sub-pixel P2 may be substantially mirror-symmetrical with respect to a vertical reference line, and the first conductive layer pattern in the third sub-pixel P3 and the first conductive layer pattern in the fourth sub-pixel P4 may be substantially mirror-symmetrical with respect to the vertical reference line. The horizontal reference line may be a straight line extending along a first direction X and bisecting a display region 110 in a second direction Y, and the vertical reference line may be a straight line extending along the second direction Y and bisecting the display region 110 in the first direction X.

After this patterning process, the first electrode plate 11, the electrode plate connection electrode 12, and the compensation connection line 13 are formed in the display region 110, and the light-transmitting region 120 has no corresponding film layer.

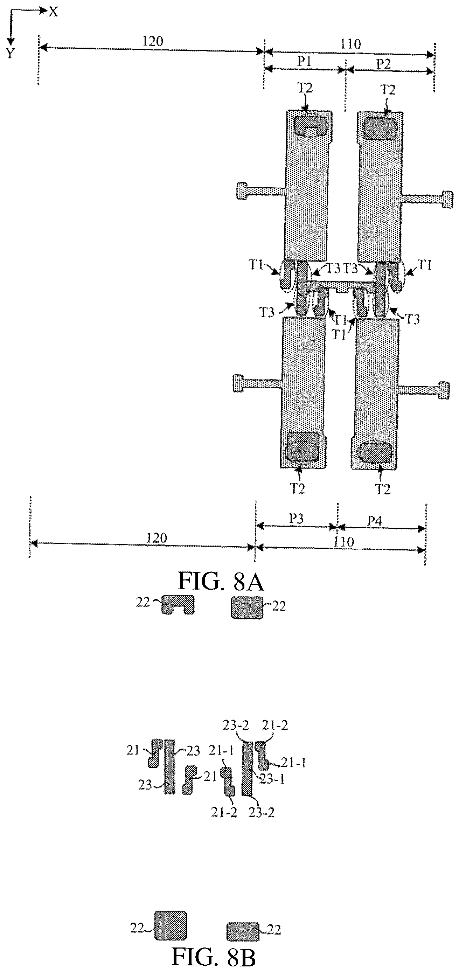

(2) Forming a pattern of a semiconductor layer. In an exemplary implementation, forming the pattern of the semiconductor layer may include: sequentially depositing a first insulation thin film and a semiconductor thin film on the base substrate on which the aforementioned pattern is formed, and patterning the semiconductor thin film through a patterning process, to form a first insulation layer covering the first conductive layer and a semiconductor layer disposed on the first insulation layer, as shown in FIGs. 8A and 8B, wherein FIG. 8B is a schematic diagram of the semiconductor layer in FIG. 8A.

In an exemplary implementation, the semiconductor layer of each sub-pixel in the display substrate may at least include a first active layer 21 as an active layer of a first transistor T1, a second active layer 22 as an active layer of a second transistor T2, and a third active layer 23 as an active layer of a third transistor T3.

In an exemplary implementation, for the first sub-pixel P1 and the second sub-pixel P2, the first active layer 21 and the third active layer 23 may be disposed on a side of the first electrode plate 11 of the sub-pixel in the second direction Y, the second active layer 22 may be disposed in a terminal region of the first electrode plate 11 of the sub-pixel away from the first active layer 21 and the third active layer 23, and an orthographic projection of the second active layer 22 on the base substrate is located within a range of an orthographic projection of the first electrode plate 11 of the sub-pixel on the base substrate, such that the first electrode plate 11 as a shielding layer can shield a channel region of the second transistor T2 to prevent light from affecting a channel and ensure an electrical performance of the second transistor T2. A third active layer 23 of the first sub-pixel P1 may be disposed on a side of a first active layer 21 of a present sub-pixel in the first direction X, and a third active layer 23 of the second sub-pixel P2 may be disposed on a side of a first active layer 21 of a present sub-pixel in an opposite direction of the first direction X.

In the exemplary implementation, for the third sub-pixel P3 and the fourth sub-pixel P4, the first active layer 21 and the third active layer 23 may be disposed on a side of the first electrode plate 11 of the sub-pixel in an opposite direction of the second direction Y, the second active layer 22 may be disposed in a terminal region of the first electrode plate 11 of the sub-pixel away from the first active layer 21 and the third active layer 23, and an orthographic projection of the second active layer 22 on the base substrate is located within a range of an orthographic projection of the first electrode plate 11 of the sub-pixel on the base substrate, such that the first electrode plate 11 as a shielding layer can shield a channel region of the second transistor T2 to prevent light from affecting a channel and ensure an electrical performance of the second transistor T2. A third active layer 23 of the third sub-pixel P3 may be disposed on a side of a first active layer 21 of a present sub-pixel in an opposite direction of the first direction X, and a third active layer 23 of the fourth sub-pixel P4 may be disposed on a side of a first active layer 21 of a present sub-pixel in the first direction X.

In an exemplary implementation, a third active layer 23 of the first sub-pixel P1 and a third active layer 23 of the third sub-pixel P3 may be of an interconnected integral structure, and a third active layer 23 of the second sub-pixel P2 and a third active layer 23 of the fourth sub-pixel P4 may be of an interconnected integral structure, that is, third active layers 23 of two sub-pixels in adjacent pixel rows may be of an interconnected integral structure. By setting that second transistors of two adjacent sub-pixels in a pixel column share a source in the present disclosure, not only space is saved, but also a via connection structure is reduced and the manufacturing process is simplified.

In an exemplary implementation, shapes of the first active layer 21 and the third active layer 23 may be an "I" shape, a shape of the second active layer 22 may be a rectangular shape, corners of the rectangular shape may be chamfered, and sides of the rectangular shape may be grooved.

In an exemplary implementation, an active layer of each transistor may include a first region, a second region, and a channel region located between the first region and the second region.

In an exemplary implementation, an orthographic projection of the first active layer 21 on the base substrate is not overlapped with an orthographic projection of the first electrode plate 11 on the base substrate, and an orthographic projection of the third active layer 23 on the base substrate is not overlapped with the orthographic projection of the first electrode plate 11 on the base substrate. In the present disclosure, by setting that there is no overlapping region between the first active layer 21 and the first electrode plate 11, and between the third active layer 23 and the first electrode plate 11, it is beneficial to design a channel width-to-length ratio of the first transistor and the third transistor according to relevant requirements.

In an exemplary implementation, the first active layer 21 and the third active layer 23 in the first sub-pixel P1 and the first active layer 21 and the third active layer 23 in the third sub-pixel P3 may be substantially mirror-symmetrical with respect to the vertical reference line, and the first active layer 21 and the third active layer 23 in the second sub-pixel P2 and the first active layer 21 and the third active layer 23 in the fourth sub-pixel P4 may be substantially mirror-symmetrical with respect to the vertical reference line.

In an exemplary implementation, the semiconductor layer may be made of a metal oxide such as an oxide containing indium and tin, an oxide containing tungsten and indium, an oxide containing tungsten, indium and zinc, an oxide containing titanium and indium, an oxide containing titanium, indium and tin, an oxide containing indium and zinc, an oxide containing silicon, indium and tin, an oxide containing indium, gallium and zinc, etc. The semiconductor layer may be a single layer, two layers, or a plurality of layers.

In an exemplary implementation, after this patterning process, the pattern of the semiconductor layer is formed in the display region 110, and a film layer of the light-transmitting region 120 includes the first insulation layer.

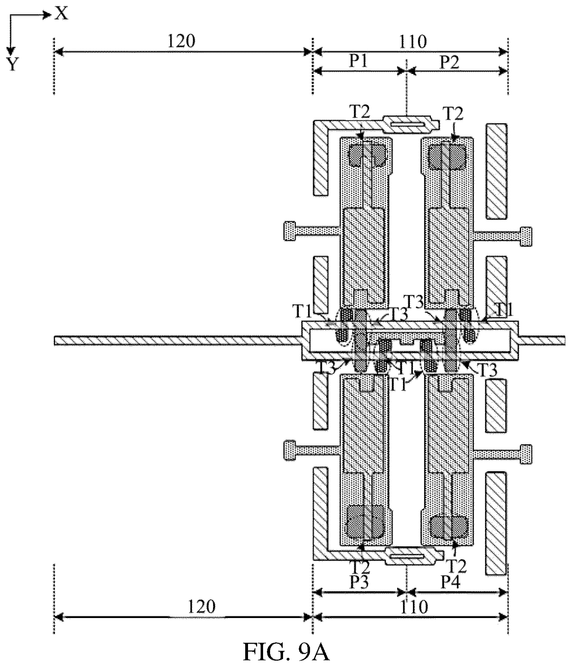

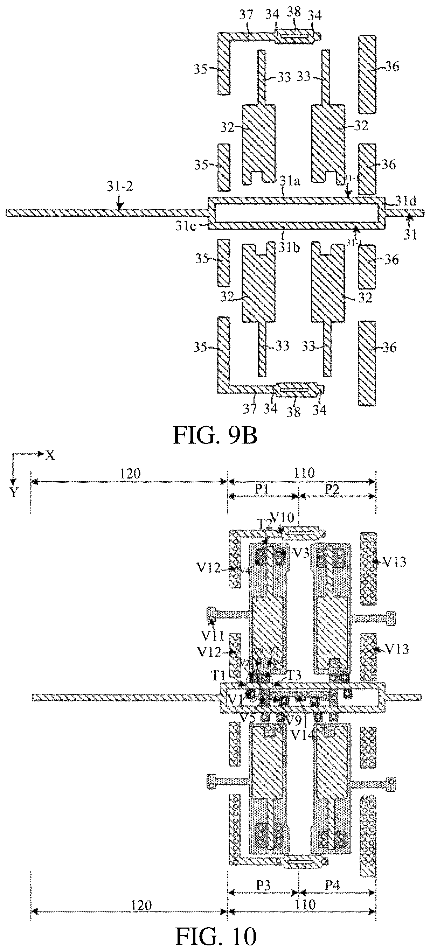

(3) Forming a pattern of a second conductive layer. In an exemplary implementation, forming the second conductive layer pattern may include: depositing a second insulation thin film and a second conductive thin film in sequence on the base substrate on which the aforementioned pattern is formed, patterning the second conductive thin film by a patterning process to form a second insulation layer covering the semiconductor layer and the second conductive layer pattern disposed on the second insulation layer, as shown in FIGs. 9A and 9B , wherein FIG. 9B is a schematic diagram of the second conductive layer in FIG. 9A.

In an exemplary implementation, the second conductive layer in the at least one repeating unit may include at least one scanning signal line 31. A shape of the scanning signal line 31 may be a line shape extending along the first direction X, the scanning signal line 31 may be disposed in a middle portion of the repeating unit in the second direction Y, i.e., between the first sub-pixel P1, the second sub-pixel P2, the third sub-pixel P3 and fourth sub-pixel P4. Regions in which the scanning signal line 31 overlaps with the plurality of first active layers may serve as gate electrodes of the plurality of first transistors T1, and regions in which the scanning signal line 31 overlaps with the plurality of third active layers may serve as gate electrodes of the plurality of third transistors T3.

In an exemplary implementation, the scanning signal line 31 may include a double-line segment 31-1 and a single-line segment 31-2, the double-line segment 31-1 may be located in the display region 110, the single-line segment 31-2 may be located in the light-transmitting region 120, that is, the display region 110 is provided with two signal lines, and the light-transmitting region 120 is provided with only one signal line.

In an exemplary implementation, the double-line segment 31-1 of the display region 110 may include a first sub-line 31a and a second sub-line 31b extending along the first direction X, the first sub-line 31a and the second sub-line 31b are arranged along the second direction Y, and the second sub-line 31b may be disposed on a side of the first sub-line 31a in the second direction Y. The first sub-line 31a may be connected with pixel driving circuits of two sub-pixels in a first pixel row, respectively, and the second sub-line 31b may be connected with pixel driving circuits of two sub-pixels in a second pixel row, respectively, thereby achieving a connection between the double-line segment 31-1 and multiple pixel driving circuits in the repeating unit.

In an exemplary implementation, an orthographic projection of the first sub-line 31a on the base substrate is at least partially overlapped with orthographic projections of the first active layer 21 and the third active layer 23 in the first sub-pixel P1 and the second sub-pixel P2 on the base substrate, respectively, and overlapping regions serve as gate electrodes of a first transistor T1 and a third transistor T3, respectively. That is, the first sub-line 31a is connected simultaneously with the gate electrode of the first transistor T1 and the gate electrode of the third transistor T3 in the first sub-pixel P1 and the second sub-pixel P2. An orthographic projection of the second sub-line 31b on the base substrate at least partially overlaps with orthographic projections of the first active layer 21 and the third active layer 23 in the third sub-pixel P3 and the fourth sub-pixel P4 on the base substrate, respectively, and the overlapped regions serve as gate electrodes of the first transistor T1 and the third transistor T3, respectively, that is, the second sub-line 31b is simultaneously connected with the gate electrode of the first transistor T1 and the gate electrode of the third transistor T3 in the third sub-pixel P3 and the fourth sub-pixel P4, respectively, such that the double-line segment 31-1 which transmits a same scan signal simultaneously controls ON or OFF of all the first transistor T1 and the third transistor T3 in the four sub-pixels of the repeating unit.

In an exemplary implementation, the double-line segment 31-1 of the display region 110 may further include a first connection line 31c and a second connection line 31d. The first connection line 31 may be connected with terminals of the first sub-line 31a and the second sub-line 31b in an opposite direction of the first direction X, respectively, and the second connection line 31d may be connected with terminals of the first sub-line 31a and the second sub-line 31b in the first direction X, respectively, such that the first connection line 31c, the first sub-line 31a, the second connection line 31d, and the second sub-line 31b are sequentially connected and constitute a ring-shaped structure. In an exemplary implementation, an annular shape may be a rectangular ring or may be a polygonal ring.

In an exemplary implementation, the single-line segment 31-2 may be located in an extending direction of the first sub-line 31a or the second sub-line 31b, the first connection line 31c may be connected with the single-line segment 31-2 of the light-transmitting region 120 in the opposite direction of the first direction X of the display region 110, the second connection line 31d may be connected with the single-line segment 31-2 of the light-transmitting region 120 in the first direction X of the display region 110, and the double-line segment 31-1 and the single-line segment 31-2 constitute a continuous scanning signal line 31. Accordingly, the double-line segment 31-1 of the display region 110 and the single-line segment 31-2 of the light-transmitting region 120 constitute a continuous scanning signal line 31.

In an exemplary implementation, for multiple repeating units sequentially disposed in the first direction X, a double-line segment 31-1 and a single-line segment 31-2 in each repeating unit may be of an interconnected integral structure, and multiple double-line segments 31-1 and multiple single-line segments 31-2 in multiple repeating units may be of an interconnected integral structure.

In an exemplary implementation, in at least one repeating unit, an orthographic projection of third active layers of an integral structure in two sub-pixels of adjacent pixel rows on the base substrate is at least partially overlapped with an orthographic projection of a ring-shaped structure of the scanning signal line 31 on the base substrate.

In an exemplary implementation, in at least one repeating unit, an orthographic projection of the compensation connection line 13 on the base substrate may be located within a range of an orthographic projection of a region enclosed by the ring-shaped structure of the scanning signal line 31 on the base substrate.

In an exemplary implementation, the second conductive layer of each sub-pixel in the display substrate may include at least a second electrode plate 32, a second gate electrode 33, and a power supply connection electrode 34.

In an exemplary implementation, the second electrode plate 32 may have a shape of a rectangle, corners of the rectangle may be chamfered, and the second electrode plate 32 may be disposed at a position of the sub-pixel close to the scanning signal line 31. An orthographic projection of the second electrode plate 32 on the base substrate is at least partially overlapped with an orthographic projection of the first electrode plate 11 on the base substrate, the second electrode plate 32 may be an intermediate electrode plate of the storage capacitor, and the first electrode plate 11 and the second electrode plate 32 form the first capacitor.

In an exemplary implementation, a side of the second electrode plate 32 away from the third active layer may be provided with an opening, the opening is configured to accommodate a subsequently formed seventh via, such that a subsequently formed third electrode plate is connected with the first electrode plate 11 through the via.

In an exemplary implementation, the second gate electrode 33 may have a strip shape extending along the second direction Y, the second gate electrode 33 may be located in a side of a second electrode plate 32 of a present sub-pixel away from the scanning signal line 31, a first terminal of the second gate electrode 33 is connected with a second electrode plate 32 of the present sub-pixel, a second terminal of the second gate electrode 33 extends along a direction away from the scanning signal line 31, and an orthographic projection of the second gate electrode 33 on the base substrate is at least partially overlapped with an orthographic projection of the second active layer 22 on the base substrate, and the second gate electrode 33 serves as the gate electrode of the second transistor T2.

In an exemplary implementation, the second electrode plate 32 and the second gate electrode 33 may be of an interconnected integral structure.

In an exemplary implementation, the power supply connection electrode 34 may have a rectangular shape, the power supply connection electrode 34 may be located in a side of the second gate electrode 33 of the present sub-pixel away from the scanning signal line 31, and the power supply connection electrode 34 is configured to be connected with the first electrode of the second transistor T2 through a subsequently formed second connection electrode.

In an exemplary implementation, the second conductive layer in the at least one repeating unit may further include a first power supply auxiliary line 35, a second power supply auxiliary line 36, a power supply connection line 37, and an electrode connection line 38.

In an exemplary implementation, a shape of the first power supply auxiliary line 35 may be a strip shape extending along the second direction Y, the first power supply auxiliary line 35 may be disposed in the first sub-pixel P1 and the third sub-pixel P3, respectively, and is located in a side of the second electrode plate 32 in the opposite direction of the first direction X, and the first power supply auxiliary line 35 is configured to be connected with a subsequently formed first power supply line, to form a double-layer trace structure with the first power supply line. In an exemplary implementation, there may be a plurality of first power supply auxiliary lines 35, and the plurality of first power supply auxiliary lines 35 may be disposed at intervals along the second direction Y.

In an exemplary implementation, the second power supply auxiliary line 36 may have a strip shape extending along the second direction Y, and may be respectively disposed in the second sub-pixel P2 and the fourth sub-pixel P4 and located in a side of the second electrode plate 32 in the first direction X, the second power supply auxiliary line 36 is configured to be connected with a second power supply line formed subsequently, to form a double-layer trace structure with the second power supply line. In an exemplary implementation, there may be a plurality of second power supply auxiliary lines 36, and the plurality of second power supply auxiliary lines 36 may be disposed at intervals along the second direction Y.

In an exemplary implementation, the power supply connection line 37 may have a strip shape extending along the first direction X, and may be respectively disposed in the first sub-pixel P1 and the third sub-pixel P3, and may be located in a side of the second gate electrode 33 of the present sub-pixel away from the scanning signal line 31. A first terminal of the power supply connection line 37 is connected with the first power supply auxiliary line 35, and a second terminal of the power supply connection line 37 is connected with the power supply connection electrodes 34 in the first sub-pixel P1 and the third sub-pixel P3 after extending along the first direction X, respectively, such that transmission of a first power supply signal to the power supply connection electrodes 34 in the first sub-pixel P1 and the third sub-pixel P3 can be realized.

In an exemplary implementation, a shape of the electrode connection line 38 may be a strip shape extending along the first direction X, the electrode connection line 38 may be located between power supply connection electrodes 34 of adjacent sub-pixels in the first direction X, and both terminals of the electrode connection line 38 in the first pixel row are respectively connected with a power supply connection electrode 34 of the first sub-pixel P1 and a power supply connection electrode 34 of the second sub-pixel P2, and both terminals of the electrode connection line 38 in the second pixel row are respectively connected with a power supply connection electrode 34 of the third sub-pixel P3 and a power supply connection electrode 34 of the fourth sub-pixel P4, such that transmission of a first power supply signal to the power supply connection electrodes 34 in the second sub-pixel P2 and the fourth sub-pixel P4 can be realized.

In an exemplary implementation, the power supply connection line 37 and the electrode connection line 38 are configured to realize a one-to-four structure of the first power supply line in one repeating unit.

In an exemplary implementation, two power supply connection electrodes 34, at least one first power supply auxiliary line 35, a power supply connection line 37, and an electrode connection line 38 in one pixel row may be interconnected as an integral structure.

In an exemplary implementation, a middle portion of the electrode connection line 38 may be provided with a strip-shaped opening (i.e. via) extending along the first direction X, such that the electrode connection line 38 forms a ring-shaped structure, so as to reduce an overlapping area of the electrode connection line 38 and a data signal line and a compensation signal line which are formed subsequently, reduce a parasitic capacitance between the first power supply line and the data signal line, reduce a parasitic capacitance between the first power supply line and the compensation signal line, and improve the display effect.

In an exemplary implementation, for patterns in the second electrode plate 32, the second gate electrode 33, and the power supply connection electrode 34 in the second conductive layer, the patterns in the first sub-pixel P1 and the patterns in the second sub-pixel P2 may be substantially mirror-symmetrical with respect to the vertical reference line, and the patterns in the third sub-pixel P3 and the patterns in the fourth sub-pixel P4 may be substantially mirror-symmetrical with respect to the vertical reference line.

In an exemplary implementation, a second conductive layer pattern in the first sub-pixel P1 and a second conductive layer pattern in the third sub-pixel P3 may be substantially mirror-symmetrical with respect to the horizontal reference line, and a second conductive layer pattern in the second sub-pixel P2 and a second conductive layer pattern in the fourth sub-pixel P4 may be substantially mirror-symmetrical with respect to the horizontal reference line.

In an exemplary implementation, for the double-line segment 31-1 in the second conductive layer, a double-line segment pattern may be substantially mirror-symmetrical with respect to the horizontal reference line and may be substantially mirror-symmetrical with respect to the vertical reference line.

In an exemplary implementation, the present process may simultaneously pattern a second conductive thin film and a second insulation thin film, such that a second insulation layer pattern is the same as a second conductive layer pattern.

In an exemplary implementation, after a first conductive layer pattern is formed, a semiconductor layer may be subjected to a conductorization treatment by using the first conductive layer as a shield, the semiconductor layer in a region shielded by the first conductive layer forms channel regions of the first transistor T1 to the third transistor T3, the semiconductor layer in a region not shielded by the first conductive layer is made to be conductive.

In the exemplary implementation, the scanning signal line 31 is formed in the display region 110 and the light-transmitting region 120, and the second electrode plate 32, the second gate electrode 33, the power supply connection electrode 34, the first power supply auxiliary line 35, the second power supply auxiliary line 36, the power supply connection line 37, and the electrode connection line 38 are formed in the display region 110, such that after the present patterning process, a film layer of the light-transmitting region 120 includes a first insulation layer and a second insulation layer, and a single-line segment of the scanning signal line is disposed on the second insulation layer.

(4) Forming a pattern of a third insulation layer. In an exemplary implementation, forming the third insulation layer pattern may include: depositing a third insulation thin film on the base substrate on which the aforementioned patterns are formed, patterning the third insulation thin film through a patterning process to form the third insulation layer pattern which covers the second conductive layer, wherein a plurality of vias are disposed on the third insulation layer, as shown in FIG. 10.

In an exemplary implementation, in the display substrate, a plurality of vias in each sub-pixel at least include: a first via V1, a second via V2, a third via V3, a fourth via V4, a fifth via V5, a sixth via V6, a seventh via V7, an eighth via V8, a ninth via V9, a tenth via V10, and an eleventh via V11.

In an exemplary implementation, an orthographic projection of the first via V1 on the base substrate is within a range of an orthographic projection of a first region of the first active layer on the base substrate, the third insulation layer and the second insulation layer within the first via V1 are etched away to expose a surface of the first region of the first active layer, and the first via V1 is configured to enable a subsequently formed data signal line to be connected with the first region of the first active layer through the via.

In an exemplary implementation, the orthographic projection of the first via V1 on the base substrate may be located within a range of an orthographic projection of a region enclosed by the ring-shaped structure of the scanning signal line 31 on the base substrate.

In an exemplary implementation, an orthographic projection of the second via V2 on the base substrate is within a range of an orthographic projection of a second region of the first active layer on the base substrate, the third insulation layer and the second insulation layer within the second via V2 are etched away to expose a surface of the second region of the first active layer, and the second via V2 is configured to enable a subsequently formed first connection electrode to be connected with the second region of the first active layer through the via.

In an exemplary implementation, an orthographic projection of the third via V3 on the base substrate is within a range of an orthographic projection of a first region of the second active layer on the base substrate, the third insulation layer and the second insulation layer within the third via V3 are etched away to expose a surface of the first region of the second active layer, and the third via V3 is configured to enable a subsequently formed second connection electrode to be connected with the first region of the second active layer through the via. In an exemplary implementation, there may be a plurality of third via V3 to increase connection reliability.

In an exemplary implementation, an orthographic projection of the fourth via V4 on the base substrate is within a range of an orthographic projection of a second region of the second active layer on the base substrate, the third insulation layer and the second insulation layer within the fourth via V4 are etched away to expose a surface of the second region of the second active layer, and the fourth via V4 is configured to enable a subsequently formed third connection electrode to be connected with the second region of the second active layer through the via. In an exemplary implementation, there may be a plurality of fourth via V4 to increase connection reliability.

In an exemplary implementation, an orthographic projection of the fifth via V5 on the base substrate is within a range of an orthographic projection of a first region of the third active layer on the base substrate, the third insulation layer and the second insulation layer within the fifth via V5 are etched away to expose a surface of the first region of the third active layer, and the fifth via V5 is configured to enable a subsequently formed fourth connection electrode to be connected with the first region of the third active layer through the via.

In an exemplary implementation, the orthographic projection of the fifth via V5 on the base substrate may be located within the range of the orthographic projection of the region enclosed by the ring-shaped structure of the scanning signal line 31 on the base substrate.

In an exemplary implementation, an orthographic projection of the sixth via V6 on the base substrate is within a range of an orthographic projection of a second region of the third active layer on the base substrate, the third insulation layer and the second insulation layer within the sixth via V6 are etched away to expose a surface of the second region of the third active layer, and the sixth via V6 is configured to enable a subsequently formed fifth connection electrode to be connected with the second region of the third active layer through the via.

In an exemplary implementation, an orthographic projection of the seventh via V7 on the base substrate is located within the range of the orthographic projection of the first electrode plate 11 on the base substrate, the third insulation layer, the second insulation layer, and the first insulation layer in the seventh via V7 are etched away to expose a surface of the first electrode plate 11, and the seventh via V7 is configured to connect a subsequently formed third electrode plate with the first electrode plate 11 through the via.

In an exemplary implementation, an orthographic projection of the eighth via V8 on the base substrate is within a range of the orthographic projection of the second electrode plate 32 on the base substrate, the third insulation layer within the eighth via V8 is etched away to expose a surface of the second electrode plate 32, and the eighth via V8 is configured to enable a subsequently formed first connection electrode to be connected with the second electrode plate 32 through the via.

In an exemplary implementation, an orthographic projection of the ninth via V9 on the base substrate is located within a range of an orthographic projection of the terminal portion of the compensation connection line 13 close to the third active layer on the base substrate, the third insulation layer, the second insulation layer, and the first insulation layer in the ninth via V9 are etched away to expose a surface of the compensation connection line 13, and the ninth via V9 is configured to enable a subsequently formed fourth connection electrode to be connected with the compensation connection line 13 through the via.

In an exemplary implementation, the orthographic projection of the ninth via V9 on the base substrate may be located within the range of the orthographic projection of the region enclosed by the ring-shaped structure of the scanning signal line 31 on the base substrate.

In an exemplary implementation, an orthographic projection of the tenth via V10 on the base substrate is located within a range of an orthographic projection of the power supply connection electrode 34 on the base substrate, the third insulation layer in the tenth via V10 is etched away to expose a surface of the power supply connection electrode 34, and the tenth via V10 is configured to enable a subsequently formed second connection electrode to be connected with the power supply connection electrode 34 through the via.

In an exemplary implementation, an orthographic projection of the eleventh via V11 on the base substrate is located within a range of an orthographic projection of the connection block 12-1 of the electrode plate connection electrode 12 on the base substrate, the third insulation layer, the second insulation layer and the first insulation layer in the eleventh via V11 are etched away to expose a surface of the connection block 12-1, and the eleventh via V11 is configured to enable a subsequently formed sixth connection electrode to be connected with the connection block 12-1 through the via.

In an exemplary implementation, the at least one repeating unit may further include a twelfth via V12, a thirteenth via V13, and a fourteenth via V14.

In an exemplary implementation, the twelfth via V12 may be disposed in the first sub-pixel P1 and the third sub-pixel P3, an orthographic projection of the twelfth via V12 on the base substrate is within a range of an orthographic projection of the first power supply auxiliary line 35 on the base substrate, the third insulation layer within the twelfth via V12 is etched away to expose a surface of the first power supply auxiliary line 35, and the twelfth via V12 is configured to enable a subsequently formed first power supply line to be connected with the first power supply auxiliary line 35 through the via. In an exemplary implementation, there may be multiple twelfth vias V12 which may be disposed sequentially along the second direction Y to improve connection reliability.

In an exemplary implementation, the thirteenth via V13 may be disposed in the second sub-pixel P2 and the fourth sub-pixel P4, an orthographic projection of the thirteenth via V13 on the base substrate is within a range of an orthographic projection of the second power supply auxiliary line 36 on the base substrate, the third insulation layer within the thirteenth via V13 is etched away to expose a surface of the second power supply auxiliary line 36, and the thirteenth via V13 is configured to enable a subsequently formed second power supply line to be connected with the second power supply auxiliary line 36 through the via. In an exemplary implementation, there may be a plurality of thirteenth vias V13, the plurality of thirteenth vias V13 may be sequentially arranged along the first direction X to form a via group, and a plurality of via groups may be sequentially arranged along the second direction Y to increase connection reliability.

In an exemplary implementation, an orthographic projection of the fourteenth via V14 on the base substrate is within a range of an orthographic projection of a middle portion of the compensation connection line 13 on the base substrate, the third insulation layer, the second insulation layer, and the first insulation layer in the fourteenth via V14 are etched away to expose a surface of the compensation connection line 13, and the fourteenth via V14 is configured to enable a subsequently formed compensation signal line to be connected with the compensation connection line 13 through the via.

In an exemplary implementation, the orthographic projection of the fourteenth via V14 on the base substrate may be located within the range of the orthographic projection of the region enclosed by the ring-shaped structure of the scanning signal line 31 on the base substrate.

In an exemplary implementation, a Half Tone Mask process may be adopted for this patterning process.

After this patterning process, a film layer of the light-transmitting region 120 includes the first insulation layer, the second insulation layer, and the third insulation layer.

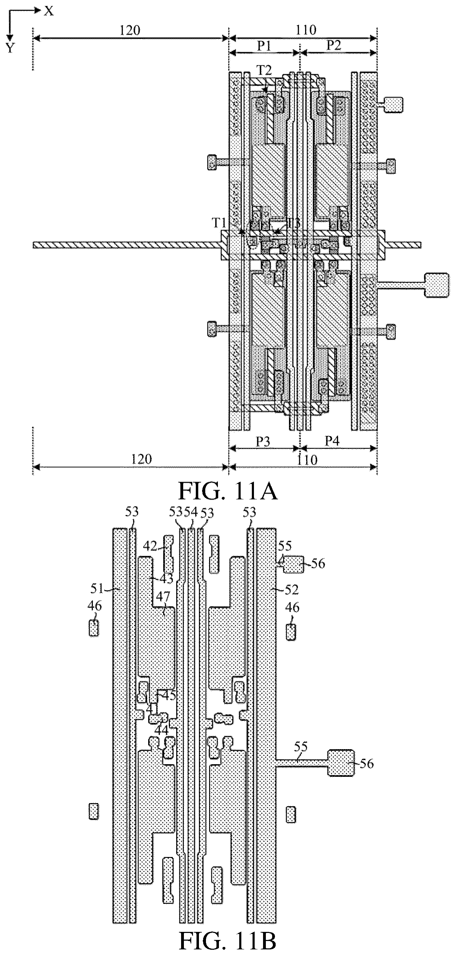

(5) Forming a pattern of a third conductive layer. In an exemplary implementation, forming the third conductive layer pattern may include: depositing a third conductive thin film on the base substrate on which the aforementioned patterns are formed, patterning the third conductive thin film by a patterning process, and forming a third conductive layer pattern on the third insulation layer, as shown in FIGs. 11A and 11B, and FIG. 11B is a schematic diagram of the third conductive layer in FIG. 1A.

In an exemplary implementation, the third conductive layer of each repeating unit in the display substrate may at least include one first power supply line 51, two second power supply lines 52, four data signal lines 53, one compensation signal line 54, two auxiliary electrode lines 55 and two first auxiliary electrodes 56.

In an exemplary implementation, shapes of the first power supply line 51, the second power supply line 52, the data signal line 53, and the compensation signal line 54 may be a linear shape in which a main body portion extends along the second direction Y, the first power supply line 51 may be located in one side of the display region 110 in the first direction X, the second power supply line 52 may be located in the other side of the display region 110 in an opposite direction of the first direction X, the compensation signal line 54 may be located between the first power supply line 51 and the second power supply line 52, two data signal lines 53 of the four data signal lines 53 may be located between the first power supply line 51 and the compensation signal line 54, the other two data signal lines 53 of the four data signal lines 53 may be located between the second power line 52 and the compensation signal line 54.

In an exemplary implementation, the first power supply line 51 may be located in a side of the display region 110 in a direction opposite to the first direction X, and the second power supply line 52 may be located in a side of the display region 110 in the first direction X . The first power supply line 51 and the compensation signal line 54 may define the first pixel column, and two data signal lines 53 are disposed in the first pixel column. The second power supply line 52 and the compensation signal line 54 may define the second pixel column, and two data signal lines 53 are disposed in the second pixel column.

In an exemplary implementation, the present disclosure arranges the first power supply line 51 and the second power supply line 52 on two sides of the display region 110, in one repeating unit, the first power supply line 51 and the second power supply line 52 are separated by two pixel driving circuits, and in two repeating units adjacent in the first direction X, the first power supply line 51 and the second power supply line 52 are separated by a light-transmitting region 120, such that the distance between the first power supply line 51 and the second power supply line 52 is relatively far, which can effectively prevent the short circuit failure caused by overlap of the first power supply line 51 and the second power supply line 52, and minimize the risk of the screen being burned out by large current caused by short circuit.

In an exemplary implementation, the positions of the first power supply line 51 and the second power supply line 52 may be substantially mirror-symmetrical with respect to the compensation signal line 54, and the two data signal lines 53 in the first pixel column and the two data signal lines 53 in the second pixel column may be substantially mirror-symmetrical with respect to the compensation signal line 54.

In an exemplary implementation, the first power supply line 51 may be connected with a plurality of first power supply auxiliary lines 35 through a plurality of twelfth vias V12, respectively, and the first power supply line 51 and the first power supply auxiliary lines 35 form a double-layer tracing structure, which ensures the reliability of power supply signal transmission, and can effectively reduce the resistance of the first power supply line, effectively reduce the voltage drop of the first power supply signal, and improve the display effect.

In an exemplary implementation, the second power supply line 52 may be connected with a plurality of second power supply auxiliary lines 36 through a plurality of thirteenth vias V13, respectively, and the second power supply line 52 and the second power supply auxiliary lines 36 form a double-layer tracing structure, which ensures the reliability of power supply signal transmission, and can effectively reduce the resistance of the second power supply line, effectively reduce the voltage drop of the second power supply signal, and improve the display effect.

In an exemplary implementation, each data signal line 53 may be connected with a first region of the first active layer in one sub-pixel through the first via V1, thereby enabling the data signal line 53 to write a data signal to the first electrode of the first transistor T1.

In an exemplary implementation, the four data signal lines 53 may include a first data signal line, a second data signal line, a third data signal line, and a fourth data signal line. The first data signal line may be located in a side of the first power supply line 51 in the first direction X, and may be connected with a first region of a first active layer in the first sub-pixel P1 through the first via V1. The second data signal line may be located in a side of the compensation signal line 54 in an opposite direction of the first direction X, and may be connected with a first region of a first active layer in the third sub-pixel P3 through the first via V1. The third data signal line may be located in a side of the compensation signal line 54 in the first direction X and may be connected with a first region of a first active layer in the fourth sub-pixel P4 through the first via V1. The fourth data signal line may be located in a side of the second power supply line 52 in the opposite direction of the first direction X, and may be connected with a first region of a first active layer in the second sub-pixel P2 through the first via V1.

In an exemplary implementation, the compensation signal line 54 may be connected with the compensation connection line 13 through the fourteenth via V14, such that the compensation signal line 54 may provide a compensation signal to the pixel driving circuit in each sub-pixel through the compensation connection line 13, and thus four pixel driving circuits in one display region 110 may share one compensation connection line 13, that is, the compensation connection line in one repeating unit has a one-to-four structure. In the display substrate according to the present disclosure, a compensation signal line is designed to have a one-drag-four structure, which saves a quantity of signal lines, reduces occupied space, has a simple structure and a reasonable layout, makes full use of layout space, improves a space utilization rate, and is beneficial to improving a resolution and transparency.

In an exemplary implementation, since the compensation signal line 54 is disposed between the first pixel column and the second pixel column, the compensation signal line 54 is connected with third transistors T3 in the first pixel column and the second pixel column through the compensation connection line 13, and the third transistor T3 of the first pixel column and the third transistor T3 of the second pixel column are symmetrically disposed with respect to the compensation signal line 54, thus such a symmetrical structure may ensure that RC delays of writing a compensation signal into the third transistors T3 are substantially the same, thereby ensuring display uniformity.

In an exemplary implementation, two auxiliary electrode lines 55 and two first auxiliary electrodes 56 may be disposed in the light-transmitting region 120 of the repeating unit. A shape of the auxiliary electrode line 55 may be a strip shape extending along the first direction X, a first terminal of the auxiliary electrode line 55 is connected with the second power supply line 52, and a second terminal of the auxiliary electrode line 55 is connected with the auxiliary electrode 55 after extending in a direction away from the second power supply line 52. A shape of the first auxiliary electrode 56 may be a rectangular shape, and the first auxiliary electrode 56 is configured to be connected with a subsequently formed second auxiliary electrode. Since the first auxiliary electrode 56 is connected with the second power supply line 52 through the auxiliary electrode line 55, the second auxiliary electrode is configured to be connected with a subsequently formed cathode, such that the connection between the second power supply line 52 and the cathode can be realized.

In an exemplary implementation, two auxiliary electrode lines 55 and two first auxiliary electrodes 56 may be disposed in the light-transmitting region 120 on a side of the second sub-pixel P2 and the fourth sub-pixel P4 in the first direction X.

In an exemplary implementation, extension lengths of the two auxiliary electrode lines 55 in the first direction X may be same or different, and areas of the two first auxiliary electrodes 56 may be same or different.

In an exemplary implementation, the second power supply line 52, the two auxiliary electrode lines 55, and the two first auxiliary electrodes 56 may be of an integral structure connected with each other.

In an exemplary implementation, considering a problem of voltage drop (IR Drop) existing in large-size transparent display, according to an implementation of the present disclosure, a second power supply line for transmitting a low-voltage signal is pertinently disposed in each repeating unit, and the second power supply line is connected with a cathode in a subsequently formed light-emitting structure layer through an auxiliary electrode, which may effectively reduce voltage drop of a second power supply signal, effectively solve the problem of voltage drop existing in the large-size transparent display, and ensure uniformity of display.

In an exemplary implementation, in the display substrate, the third conductive layer of each sub-pixel may at least include a first connection electrode 41, a second connection electrode 42, a third connection electrode 43, a fourth connection electrode 44, a fifth connection electrode 45, a sixth connection electrode 46, and a third electrode plate 47.

In an exemplary implementation, a shape of the first connection electrode 41 may be a strip shape in which a main body portion extends along the second direction Y, a first terminal of the first connection electrode 41 is connected with the second region of the first active layer through the second via V2, and a second terminal of the first connection electrode 41 is connected with the second electrode plate 32 through the eighth via V8, such that the second electrode of the first transistor T1 and the second electrode plate 32 of each sub-pixel have the same potential.

In an exemplary implementation, a shape of the second connection electrode 42 may be a strip shape in which a main body portion extends along the second direction Y, a first terminal of the second connection electrode 42 is connected with the first region of the second active layer through the third via V3, and a second terminal of the second connection electrode 42 is connected with the power supply connection electrode 34 through the tenth via V10. Since the power supply connection electrode 34 is connected with the first power supply auxiliary line 35 through the power supply connection line 37, and the first power supply auxiliary line 35 is connected with the first power supply line through the via, such that the first power supply line is connected with the first region of the second active layer, and the first power supply line can write the first power supply signal to the first electrode of the second transistor T2 of each sub-pixel.

In an exemplary implementation, a shape of the third connection electrode 43 may be a strip shape in which a main body portion extends along the second direction Y, a first terminal of the third connection electrode 43 is connected with the third electrode plate 47, and a second terminal of the third connection electrode 43 is connected with the second region of the second active layer through the fourth via V4, such that the second electrode of the second transistor T2 and the third electrode plate 47 of each sub-pixel have a same potential.

In an exemplary implementation, a shape of the fourth connection electrode 44 may be a strip shape in which a main body portion extends along the first direction X, a first terminal of the fourth connection electrode 44 is connected with the first region of the third active layer through the fifth via V5, and a second terminal of the fourth connection electrode 44 is connected with the compensation connection line 13 through the ninth via V9. Since the compensation connection line 13 is connected with the compensation signal line through a via, it is realized that the compensation signal line is connected with the first region of the third active layer, and the compensation signal line can write a compensation signal to the first electrode of the third transistor T3 of each sub-pixel.

In an exemplary implementation, a shape of the fifth connection electrode 45 may be a strip shape in which a main body portion extends along the second direction Y, a first terminal of the fifth connection electrode 45 is connected with the third electrode plate 47, and a second terminal of the fifth connection electrode 45 is connected with the second region of the third active layer through the sixth via V6, such that the second electrode of the third transistor T3 and the third electrode plate 47 of each sub-pixel have a same potential.

In an exemplary implementation, a shape of the sixth connection electrode 46 may be a rectangular shape, an orthographic projection of the sixth connection electrode 46 on the base substrate at least partially overlaps with an orthographic projection of the connection block 12-1 of the electrode plate connection electrode on the base substrate, the sixth connection electrode 46 is connected with the connection block 12-1 through the eleventh via V11, and the sixth connection electrode 46 is configured to be connected with a subsequently formed anode connection electrode.

In an exemplary implementation, a shape of the third electrode plate 47 may be a rectangular shape, the corner portions of the rectangular shape may be chamfered, the third electrode plate 47 may be provided at a position in the present sub-pixel close to the scanning signal line 31, and the third electrode plate 47 is connected with the first electrode plate 11 through the seventh via V7. An orthographic projection of the third electrode plate 47 on the base substrate is at least partially overlapped with the orthographic projection of the second electrode plate 32 on the base substrate. The third electrode plate 47 may serve as an upper electrode plate of the storage capacitor, and the second electrode plate 32 and the third electrode plate 47 form the second capacitor.

In an exemplary implementation, the third connection electrode 43, the fifth electrode plate 45 and the third electrode plate 47 may be of an interconnected integral structure.

In the exemplary implementation, since the first connection electrode 41 is connected with the second electrode plate 32, and the second electrode plate 32 is connected with the second gate electrode 33, therefore, the first connection electrode 41 makes the second electrode of the first transistor T1, the gate electrode of the second transistor T2, and the first terminal of the storage capacitor (including the second electrode plate 32) have a same potential, and the first connection electrode 41 may serve as a first node N1 of the pixel driving circuit.

In an exemplary implementation, since the third connection electrode 43 is connected with the second region of the second active layer, the fifth connection electrode 45 is connected with the second region of the third active layer, the third connection electrode 43 is connected with the fifth connection electrode 45 and the third electrode plate 47, the first electrode plate 11 is connected with the third electrode plate 47, therefore, the third connection electrode 43 and the fifth connection electrode 45 make the second electrode of the second transistor T2, the second electrode of the third transistor T3, and the second terminal of the storage capacitor (including the first electrode plate 11 and the third electrode plate 47) have a same potential, and the third connection electrode 43 and the fifth connection electrode 45 may serve as a second node N2 in the pixel driving circuit.

In the exemplary implementation, since the second electrode plate 32 has the potential of the first node N1, and the first electrode plate 11 and the third electrode plate 47 have the potential of the second node N2, therefore, the second node N2 having the potential of the first node N1 and the first electrode plate 11 having the potential of the second node N2 constitute the first capacitor of the pixel driving circuit, and the second node N2 having the potential of the first node N1 and the third electrode plate 47 having the potential of the second node N2 constitute the second capacitor of the pixel driving circuit, and the first capacitor and the second capacitor are connected in parallel. The present disclosure utilizes the first conductive layer, the second conductive layer and the third conductive layer to form the first capacitor and the second capacitor of the parallel structure. The first capacitor and the second capacitor of the parallel structure constitute the storage capacitor of a complete pixel driving circuit. On the one hand, a capacitance value of the storage capacitor can be effectively increased, on the other hand, an area of an electrode plate can be reduced while guaranteeing the capacitance value of the storage capacitor, thereby effectively reducing the occupied area.

In the exemplary implementation, since the first power supply auxiliary line 35 is connected with two power supply connection electrodes 34 in one pixel row through the power supply connection line 37 and the electrode connection line 38, and the first power supply line 51 is connected with the first power supply auxiliary line 35, therefore, four pixel driving circuits in one display region 110 may share one first power supply line 51, that is, the first power supply line in one repeating unit has a one-to-four structure, which can reduce the occupied space of the display region, improve an area ratio of the light-transmitting region, and improve the resolution and transparency.

In an exemplary implementation, in at least one repeating unit, orthographic projections of the first power supply line 51, the second power supply line 52, the data signal line 53, and the compensation signal line 54 on the base substrate at least partially overlaps with the orthographic projection of the ring-shaped structure of the scanning signal line 31 on the base substrate.

After this patterning process, a film layer of the light-transmitting region 120 includes the first insulation layer, the second insulation layer, and the third insulation layer.

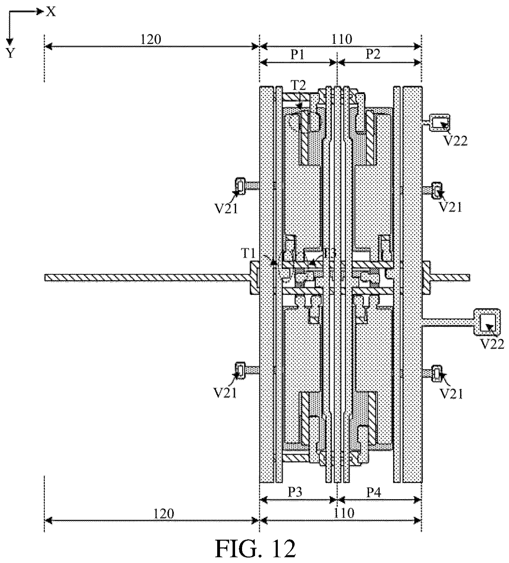

(6) Patterns of a fourth insulation layer and a first planarization layer are formed. In an exemplary implementation, forming the patterns of the fourth insulation layer and the first planarization layer may include: first depositing a fourth insulation thin film on the base substrate on which the aforementioned patterns are formed, then coating a first planarization thin film, and patterning the fourth insulation thin film and the first planarization thin film by a patterning process to form a fourth insulation layer which covers the third conductive layer and to form a first planarization layer pattern disposed on the fourth insulation layer, the fourth insulation layer and the first planarization layer are provided with a plurality of vias, as shown in FIG. 12.

In the exemplary implementation, the first planarization layer is only provided in the display region 110, and the first planarization layer located in the light-transmitting region 120 is completely removed, the region in which the first planarization layer is completely removed includes the region in which the electrode plate connection electrode 12 and the first auxiliary electrode 56 are located.

In an exemplary implementation, the at least one repeating unit may at least include four twenty-first vias V21 and two twenty-second vias V22.

In an exemplary implementation, an orthographic projection of each twenty-first via V21 on the base substrate is located within a range of the orthographic projection of the sixth connection electrode 46 on the base substrate, the fourth insulation layer in the twenty-first via V21 is etched away to expose a surface of the sixth connection electrode 46, and the twenty-first via V21 is configured to make a subsequently formed anode connection electrode connect with the sixth connection electrode 46 through the via.

In an exemplary implementation, an orthographic projection of each twenty-second via V22 on the base substrate is within a range of an orthographic projection of the first auxiliary electrode 56 on the base substrate, the fourth insulation layer within the twenty-second via V22 is etched away to expose a surface of the first auxiliary electrode 56, and the twenty-second via V22 is configured to make a subsequently formed second auxiliary electrode connect with the first auxiliary electrode 56 through the via.

In an exemplary implementation, a Half Tone Mask process may be adopted for this patterning process.

After this patterning process, a film layer of the light-transmitting region 120 includes the first insulation layer, the second insulation layer, the third insulation layer and the fourth insulation layer.

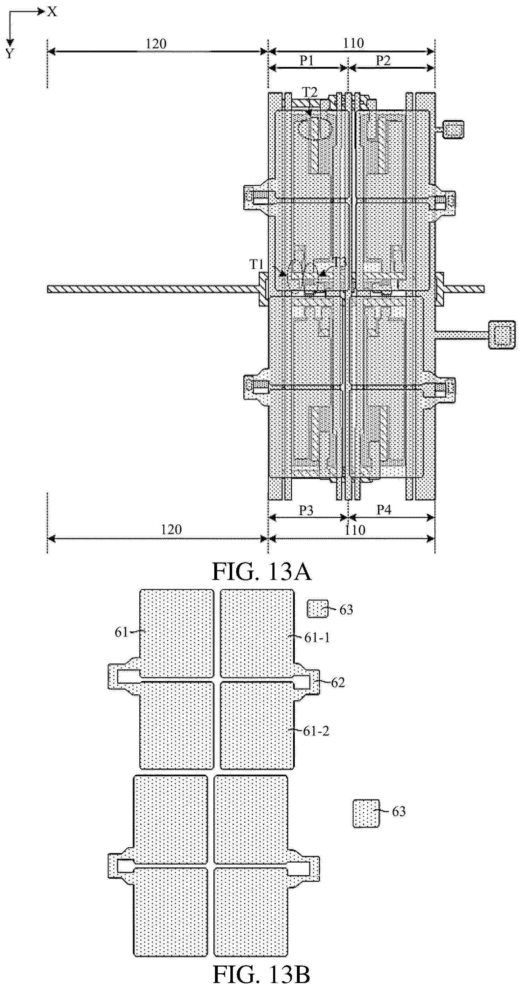

(7) Forming a pattern of a fourth conductive layer. In an exemplary implementation, forming the fourth conductive layer pattern may include: depositing a fourth conductive thin film on the base substrate on which the aforementioned patterns are formed, patterning the fourth conductive thin film through a patterning process, to form the fourth conductive layer pattern, as shown in FIGs. 13A and 13B, wherein FIG. 13B is a schematic diagram of the fourth conductive layer in FIG. 3A.

In an exemplary implementation, the fourth conductive layer of each sub-pixel in the display substrate may at least include a first anode 61 and an anode connection electrode 62.

In an exemplary implementation, the first anode 61 in at least one sub-pixel may include a first sub-anode 61-1 and a second sub-anode 61-2 disposed in isolation, shapes of the first sub-anode 61-1 and the second sub-anode 61-2 may be a rectangular shape, the first sub-anode 61-1 and the second sub-anode 61-2 may be located in the display region 110, and may be disposed on the first planarization layer, and the first sub-anode 61-1 and the second sub-anode 61-2 may be disposed sequentially along the second direction Y.

In an exemplary implementation, a shape of the anode connection electrode 62 may be a "C" shape, the anode connection electrode 62 may be located in the light-transmitting region 120, and disposed on the fourth insulation layer, a first terminal of the anode connection electrode 62 is connected with the first sub-anode 61-1, a second terminal of the anode connection electrode 62 is connected with the second sub-anode 61-2, and a region between the first terminal and the second terminal is connected with the sixth connection electrode 46 through the twenty-first via V21. In an exemplary implementation, the anode connection electrode 62 achieves a mutual connection between the first sub-anode 61-1 and the second sub-anode 61-2. Since the sixth connection electrode 46 is connected with the electrode plate connection electrode 12, and the electrode plate connection electrode 12 is connected with the first electrode plate 11, therefore, the anode connection electrode 62 realizes the connection between the first anode 61 and the first electrode plate 11 of the storage capacitor.

In an exemplary implementation, when a bright spot defect occurs on the display substrate, the anode connection electrode 62 may be truncated through a laser cutting manner, such that one of the first sub-anode 61-1 and the second sub-anode 61-2 is connected with the first electrode plate 11 while the other is floating, thus the bright spot defect may be repaired.

In an exemplary implementation, the twenty-first via V21 may be referred to as an anode via, and an orthographic projection of the anode via on the base substrate is not overlapped with orthographic projections of the first sub-anode 61-1 and the second sub-anode 61-2 on the base substrate, which may not only improve a success rate of repairing the bright spot defect and avoid an influence of repairing on the pixel driving circuit, but also may ensure flatness of the anode, improve light output quality of the light-emitting device, and improve a display effect.

In an exemplary implementation, four first anodes 61 are arranged in a square, an upper left first anode 61 is connected with the pixel driving circuit in the first sub-pixel P1, an upper right first anode 61 is connected with the pixel driving circuit in the second sub-pixel P2, a lower left first anode 61 is connected with the pixel driving circuit in the third sub-pixel P3, and a lower right first anode 61 is connected with the pixel driving circuit in the fourth sub-pixel P4. In some possible Implementations, an arrangement mode of the anodes may be adjusted according to actual needs, which is not specifically limited herein in the present disclosure.

In an exemplary implementation, the first sub-anode 61-1, the second sub-anode 61-2, and the anode connection electrode 62 of each sub-pixel may be of an interconnected integral structure.

In an exemplary implementation, the fourth conductive layer of at least one repeating unit may further include a second auxiliary electrode 63. The second auxiliary electrode 63 may have a rectangular shape, and an orthographic projection of the second auxiliary electrode 63 on the base substrate is at least partially overlapped with an orthographic projection of the first auxiliary electrode 56 on the base substrate. The second auxiliary electrode 63 may be connected with the first auxiliary electrode 56 through the twenty-second via V22, and the second auxiliary electrode 63 is configured to be connected with a subsequently formed third auxiliary electrode.

In an exemplary implementation, the fourth conductive layer may be made of a transparent conductive material, such as Indium Tin Oxide (ITO) or Indium Zinc Oxide (IZO).

After this patterning process, the film layer of the light-transmitting region 120 does not change.

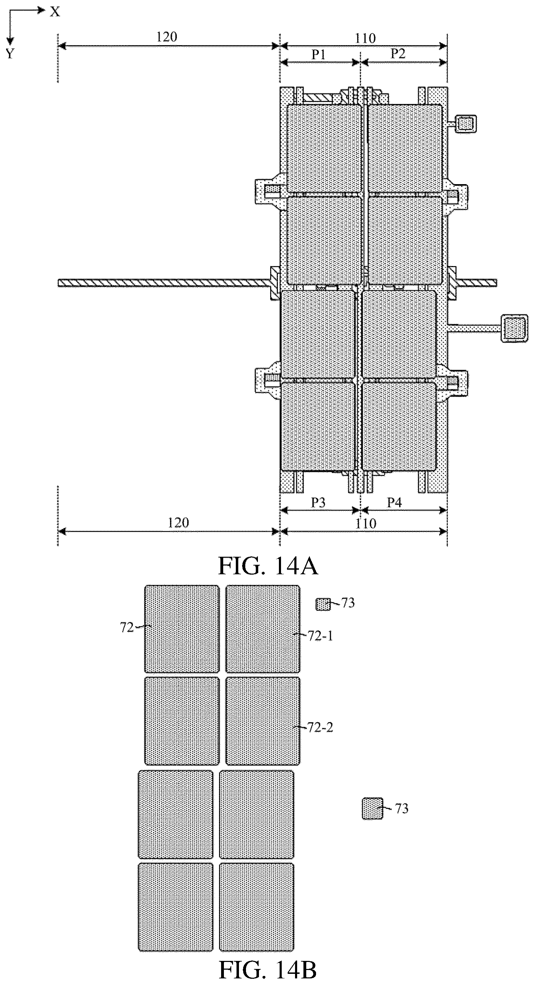

(8) Forming a pattern of a fifth conductive layer. In an exemplary implementation, forming the fifth conductive layer pattern may include: depositing a fifth conductive thin film on a base substrate on which the aforementioned patterns are formed, and patterning the fifth conductive thin film by a patterning process to form a fifth conductive layer pattern, as shown in FIGs. 14A and 14B, and FIG. 14B is a schematic diagram of the fifth conductive layer in FIG. 4A.

In an exemplary implementation, the fifth conductive layer of each sub-pixel in the display substrate may include at least a second anode 72.

In an exemplary implementation, the second anode 72 may include a third sub-anode 72-1 and a fourth sub-anode 72-2 disposed in isolation, shapes of the third sub-anode 72-1 and the fourth sub-anode 72-2 may be rectangular, the third sub-anode 72-1 and the fourth sub-anode 72-2 may be located in the display region 110, and may be disposed respectively on the first sub-anode 61-1 and the second sub-anode 61-2, the third sub-anode 72-1 and the fourth sub-anode 72-2 may be sequentially disposed along the second direction Y, an orthographic projection of the third sub-anode 72-1 on the base substrate at least partially overlaps with an orthographic projection of the first sub-anode 61-1 on the base substrate, the third sub-anode 72-1 is connected with the first sub-anode 61-1, an orthographic projection of the fourth sub-anode 72-2 on the base substrate at least partially overlaps with an orthographic projection on the substrate, and the fourth sub-anode 72-2 is connected to the second sub-anode 61-2.

In an exemplary implementation, the fifth conductive layer of the at least one repeating unit may further include a third auxiliary electrode 73. A shape of the third auxiliary electrode 73 may be a rectangular shape, the second auxiliary electrode 63 may be disposed on the second auxiliary electrode 63, an orthographic projection of the second auxiliary electrode 63 on the base substrate at least partially overlaps with an orthographic projection of the second auxiliary electrode 63 on the base substrate, the second auxiliary electrode 63 is connected with the second auxiliary electrode 63, and the third auxiliary electrode 73 is configured to be connected with a subsequently formed cathode.

In an exemplary implementation, a post spacer (RIB) structure may be adopted for the third auxiliary electrode 73, and a cross-sectional shape of the third auxiliary electrode 73 may be an inverted trapezoid, so that a subsequently formed organic emitting layer may be disconnected at a side edge of the third auxiliary electrode 73 to form an independent and isolated organic light emitting block, which effectively avoids interference of the organic light emitting block on outgoing light, and improves quality of the outgoing light, thereby facilitating improvement of display quality.

In an exemplary implementation, the first auxiliary electrode 56, the second auxiliary electrode 63, and the third auxiliary electrode 73 which are stacked constitute an auxiliary cathode.

In an exemplary implementation, the fifth conductive layer may be made of a transparent conductive material, such as Indium Tin Oxide (ITO) or Indium Zinc Oxide (IZO).

After this patterning process, the film layer of the light-transmitting region 120 does not change.

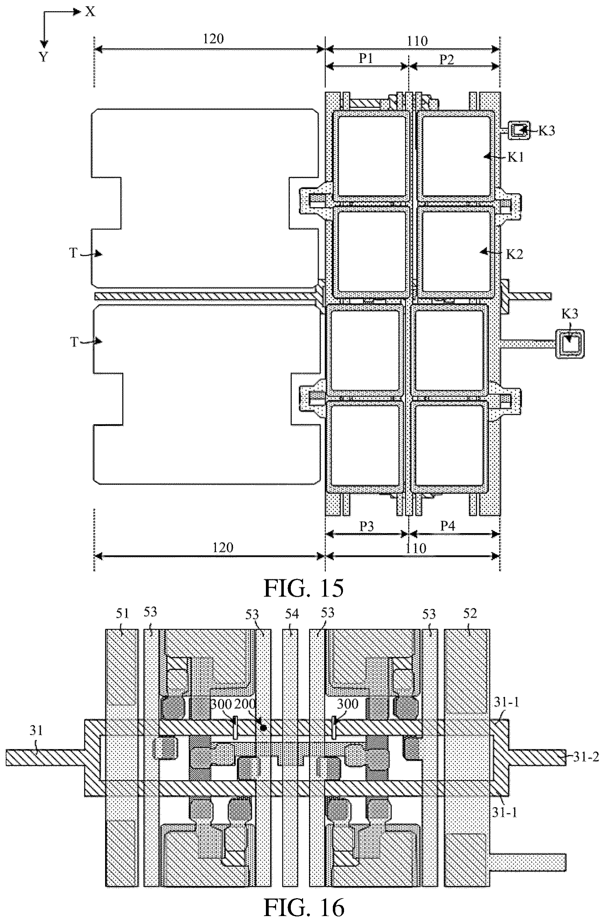

(9) A pixel definition layer is formed. In an exemplary implementation, forming a pattern of the pixel definition layer may include: coating a pixel definition thin film on the base substrate on which the aforementioned patterns are formed, patterning the pixel definition thin film through a patterning process, to form the pixel definition layer, as shown in FIG. 15.

In an exemplary implementation, a first pixel opening K1 and a second pixel opening K2 are opened on the pixel definition layer of each sub-pixel in the display substrate, the pixel definition thin film in the first pixel opening K1 is removed to expose a part of a surface of the third sub-anode 72-1 in the second anode 72, and the pixel definition thin film in the second pixel opening K2 is removed to expose a part of a surface of the fourth sub-anode 72-2 in the second anode 72.

In an exemplary implementation, an orthographic projection of the first pixel opening K1 on the base substrate is within a range of the orthographic projection of the third sub-anode 72-1 on the base substrate, and an orthographic projection of the second pixel opening K2 on the base substrate is within a range of the orthographic projection of the fourth sub-anode 72-2 on the base substrate.

In an exemplary implementation, in a plane parallel to the base substrate, shapes of the first pixel opening K1 and the second pixel opening K2 may be similar to the shapes of sub-anodes, and in a plane perpendicular to the base substrate, cross-sectional shapes of the first pixel opening K1 and the second pixel opening K2 may be rectangles or trapezoids or the like.

In an exemplary implementation, an auxiliary electrode opening K3 is opened in the pixel definition layer of the at least one repeating unit, the pixel definition thin film in the auxiliary electrode opening K3 is removed to expose a part of a surface of the third auxiliary electrode 73, and an orthographic projection of the auxiliary electrode opening K3 on the base substrate is within a range of an orthographic projection of the third auxiliary electrode 73 on the base substrate.

In an exemplary implementation, in a plane parallel to the base substrate, a shape of the auxiliary electrode opening K3 may be similar to the shape of the third auxiliary electrode 73, and in a plane perpendicular to the base substrate, a shape of a cross-section of the auxiliary electrode opening K3 may be rectangular, trapezoidal or the like on .

In an exemplary implementation, the pixel definition layer of the light-transmitting region 120 is substantially removed to form a light-transmitting opening T, a side of the light-transmitting opening T close to the display region 110 may be provided with grooves, and pixel definition blocks provided in the grooves may shield the anode connection electrodes 62.

In an exemplary implementation, the pixel definition layer may be made of polyimide, acrylic, or polyethylene terephthalate, etc.

(10) Patterns of an organic emitting layer and a cathode are formed. In an exemplary implementation, forming the organic light-emitting layer and the cathode pattern may include: first forming an organic light-emitting layer pattern in the display region 110, and the organic light-emitting layer is connected with the third sub-anode 72-1 and the fourth sub-anode 72-2 through the first pixel opening K1 and the second pixel opening K2, respectively. Subsequently, a cathode is formed, the cathode is connected with the organic light-emitting layer in the display region 110, and the cathode is connected with the third auxiliary electrode 73 through the auxiliary electrode opening K3 in the light-transmitting region 120. Since the third auxiliary electrode 73 is connected with the second power supply line, therefore, connection between the cathode and the second power supply line is realized.

In an exemplary implementation, the organic emitting layer may include an Emitting Layer (EML) and any one or more of following: a Hole Injection Layer (HIL), a Hole Transport Layer (HTL), an Electron Block Layer (EBL), a Hole Block Layer (HBL), an Electron Transport Layer (ETL), and an Electron Injection Layer (EIL). In an exemplary implementation, the organic emitting layer may be formed through evaporation using a Fine Metal Mask (FMM) or an Open Mask, or through an inkjet process.

In an exemplary implementation, a process of manufacturing the display substrate may include forming an encapsulation layer pattern. Forming the encapsulation layer pattern may include: first depositing a first inorganic thin film using an open mask to form a first encapsulation layer. Then, inkjet printing an organic material is performed on the first encapsulation layer by using an inkjet printing process, and a second encapsulation layer is formed after curing. and then depositing a second inorganic thin film by using an open mask to form a third encapsulation layer, wherein the first encapsulation layer, the second encapsulation layer and the third encapsulation layer form the encapsulation layer. The first encapsulation layer and the third encapsulation layer may be made of any one or more of Silicon Oxide (SiOx), Silicon Nitride (SiNx), Silicon Carbide (SiC), Silicon Carbonitride (SiCN), and Silicon Oxynitride (SiON), and may be a single layer, a multi-layer, or a composite layer. The second encapsulation layer may be made of a resin material, thereby forming a stacked structure of an inorganic material/an organic material/an inorganic material, wherein an organic material layer is disposed between two inorganic material layers, thus ensuring that external water vapor cannot enter a light-emitting structure layer.

In an exemplary implementation, the manufacturing process of the display substrate may further include forming a color film layer and a black matrix, the black matrix having a plurality of opening regions arranged in a matrix, and the color film layer is filled in the opening regions.

So far, the manufacturing of the display substrate according to an exemplary implementation of the present disclosure is completed.

In an exemplary implementation, the base substrate may be a flexible base substrate, or a rigid base substrate. The rigid base substrate may be made of, but is not limited to, one or more of glass and quartz. The flexible base substrate may be made of, but is not limited to, one or more of polyethylene terephthalate, ethylene terephthalate, polyether ether ketone, polystyrene, polycarbonate, polyarylate, polyarylester, polyimide, polyvinyl chloride, polyethylene, and textile fiber. In an exemplary implementation, the flexible substrate may include a first flexible material layer, a first inorganic material layer, a semiconductor layer, a second flexible material layer, and a second inorganic material layer which are stacked, wherein materials of the first flexible material layer and the second flexible material layer may be Polyimide (PI), Polyethylene Terephthalate (PET), or a surface-treated polymer soft film, or the like, materials of the first inorganic material layer and the second inorganic material layer may be Silicon Nitride (SiNx) or Silicon Oxide (SiOx), or the like, for improving a water and oxygen resistance capability of the substrate, and a material of the semiconductor layer may be amorphous silicon (a-si).

In an exemplary implementation, the first conductive layer, the second conductive layer, and the third conductive layer may be made of a metal material, for example, any one or more of Argentum (Ag), Copper (Cu), Aluminum (Al), and Molybdenum (Mo), or an alloy material of the aforementioned metals, for example, an Aluminum-Neodymium alloy (AlNd) or a Molybdenum-Niobium alloy (MoNb), and may be in a single-layer structure, or in a multilayer composite structure such as Mo/Cu/Mo, etc. The first insulation layer, the second insulation layer, the third insulation layer, and the fourth insulation layer may be made of any one or more of Silicon Oxide (SiOx), Silicon Nitride (SiNx), and Silicon Oxynitride (SiON), and may be a single layer, a multi-layer, or a composite layer. The first planarization layer may be made through an organic material such as resin.

FIG. 16 is a schematic diagram of short circuit defect repair of a display substrate according to an exemplary embodiment of the present disclosure. As shown in 16, when a short-circuit point 200 occurs between the scan connection line 31 and other signal lines (such as the data signal line 53), the first sub-line on both sides of the short-circuit point 200 may be cut off by laser cutting, and two cut-off points 300 are formed on both sides of the short-circuit point 200, respectively, to isolate the short-circuit point 200. Since the scan connection line 31 of the display region is a double-line segment 31-1 of a double-line structure and has a dual-channel function, therefore, the truncation points 300 do not affect the pixel driving circuit, which can not only ensure that the scanning signal line drives all the pixel driving circuits in the repetition region, but can also repair the short circuit points 200 at all positions, achieves the repair of short circuit failure of all signals, avoids product scrapping, and effectively improves product yield.

As can be seen from the structure and manufacturing process of the display substrate described above, the display substrate provided by the present disclosure adopts a 3T1C pixel driving circuit with one scanning signal line, and one scanning signal line is connected with the first transistor and the third transistor in the pixel driving circuit. By reducing the number of scanning signal lines, not only the structure of the pixel driving circuit can be simplified, the occupied area of the pixel driving circuit can be reduced, which is conducive to achieving high-resolution display, but also the light-transmitting area of the light-transmitting region can be effectively increased, and the space ratio of the light-transmitting region can be increased, which is conducive to achieving high-transparency display. In addition, since one repeating unit only needs to be driven by one scanning signal line, a quantity of corresponding gate drive circuits (GOA) and clock signal lines (CLK) may be reduced by a plurality of times, areas occupied by the gate drive circuits and clock signal lines are effectively reduced, which is beneficial to achieving a narrow bezel, and improving product advantages.

In an exemplary embodiment of the present disclosure, by providing the single-line structure in the light-transmitting region and the double-line structure in the display region, it can not only ensure that the scanning signal line drives all the pixel driving circuits in the repetition region, but also realizes the dual-channel function, which can repair signal lines at all positions, achieves the repair of short circuit failure of all signals, and effectively improves product yield.

In the exemplary embodiment of the present disclosure, the first capacitor and the second capacitor of a three-layer metal layout sandwich structure are formed by using the first conductive layer, the second conductive layer, and the third conductive layer. The first capacitor and the second capacitor in the parallel structure form the storage capacitor, on one hand, a capacitance value of the storage capacitor may be effectively increased, and on the other hand, an area of an electrode plate may be reduced under a condition of ensuring the capacitance value of the storage capacitor, an occupied area of a pixel driving circuit may be effectively reduced, which is beneficial to achieving high-resolution display.

According to the exemplary embodiment of the present disclosure, by disposing a one-to-four structure of the first power supply line and a one-to-four structure of the compensation signal line, a quantity of signal lines is saved, occupied space is saved, a structure is simple, a layout is reasonable, layout space is fully utilized, and a space utilization rate is improved, and it is beneficial to improve a resolution.

In the exemplary embodiment of the present disclosure, by providing the anode connection electrode to connect the first sub-anode and the second sub-anode respectively, not only the success rate of repairing bright spot defect can be improved, the influence of the repair on the pixel driving circuit is avoided, but also other defects are not caused, the success rate of repairing is high, and the flatness of the anode can be ensured, light output quality of the light-emitting devices are improved, and the display effect is improved.

In the exemplary embodiment of the present disclosure, by providing the second power supply line and auxiliary electrodes, the second power supply line is connected with the cathode through the auxiliary electrodes, a voltage drop of the second power supply can be effectively reduced, and display uniformity can be ensured.

In the exemplary embodiment of the present disclosure, the anode connection electrode and the auxiliary electrodes are disposed in the light-transmitting region, and the light-transmitting region is changed into an irregular shape. Since when light passes through the light-transmitting region with an irregular shape, diffraction fringes are generated in different positions and different directions, therefore, the diffraction fringes generated by the light do not diffuse in one direction, but in a plurality of directions, thereby greatly weakening the diffraction effect, avoiding a blur phenomenon of objects behind the screen, and improving the transparent display effect.

The manufacturing process according to the exemplary embodiment of the present disclosure may be compatible well with an existing manufacturing process, and the process is simple to achieve and is easy to implement, and has a high production efficiency, a low production cost, and a high yield.

The aforementioned structure shown in the present disclosure and the manufacturing process thereof are merely exemplary description. In an exemplary implementation, corresponding structures may be changed and patterning processes may be added or reduced according to actual needs, which is not limited here in the present disclosure.

In an exemplary implementation, the display substrate according to the present disclosure may be applied to a display device with a pixel driving circuit, such as an OLED, quantum dot display (QLED), light emitting diode display (Micro LED or Mini LED), or Quantum Dot Light Emitting Diode display (QDLED), which is not limited here in the present disclosure.

The present disclosure also provides a manufacturing method for a display substrate, for manufacturing the display substrate according to the foregoing embodiments. In an exemplary implementation, the display substrate includes a plurality of repeating units arranged regularly, the repeating units include a display region and a light-transmitting region located in at least one side of the display region, the display region is configured to perform image display, and the light-transmitting region is configured to transmit light; the display region includes a plurality of sub-pixels forming at least two pixel rows and two pixel columns, the sub-pixels include a pixel driving circuit; the manufacturing method includes:
forming a pixel driving circuit in the sub-pixels; the pixel driving circuit includes a first transistor, a second transistor, a third transistor and a storage capacitor, a first electrode of the first transistor is connected with a data signal line, a second electrode of the first transistor is connected with a gate electrode of the second transistor and a first terminal of the storage capacitor, a first electrode of the second transistor is connected with a first power supply line, a second electrode of the second transistor is connected with a second electrode of the third transistor and a second terminal of the storage capacitor respectively, a first electrode of the third transistor is connected with a compensation signal line, and a gate electrode of the first transistor and a gate electrode of the third transistor are connected with a same scanning signal line.

A display device which includes the aforementioned display substrate is also provided in the present disclosure. The display device may be any product or component with a display function, such as a mobile phone, a tablet computer, a television, a display, a laptop computer, a digital photo frame, and a navigator, which is not limited in the embodiments of the present invention.

Although implementations disclosed in the present disclosure are described as above, the described contents are only implementations which are used for facilitating understanding of the present disclosure, but are not intended to limit the present invention. Any skilled person in the art to which the present disclosure pertains may make any modification and variation in a form and details of implementation without departing from the spirit and scope of the present disclosure. However, the patent protection scope of the present invention should be subject to the scope defined in the appended claims.

## Claims

1. A display substrate comprising a plurality of repeating units arranged regularly, wherein:
the repeating units comprises a display region and a light-transmitting region located in at least one side of the display region, the display region is configured to perform image display, and the light-transmitting region is configured to transmit light;
the display region comprises a plurality of sub-pixels forming at least two pixel rows and two pixel columns, and the sub-pixels comprise a pixel driving circuit; and
the pixel driving circuit comprises a first transistor, a second transistor, a third transistor and a storage capacitor, a first electrode of the first transistor is connected with a data signal line, a second electrode of the first transistor is connected with a gate electrode of the second transistor and a first terminal of the storage capacitor respectively, a first electrode of the second transistor is connected with a first power supply line, a second electrode of the second transistor is connected with a second electrode of the third transistor and a second terminal of the storage capacitor respectively, a first electrode of the third transistor is connected with a compensation signal line, and in the pixel driving circuit of at least one sub-pixel, a gate electrode of the first transistor and a gate electrode of the third transistor are connected with a same scanning signal line.

2. The display substrate according to claim 1, wherein in a plurality of pixel driving circuits of at least one pixel row, gate electrodes of a plurality of first transistors and gate electrodes of a plurality of third transistors are connected with a same scanning signal line.

3. The display substrate according to claim 1, wherein in a plurality of pixel driving circuits of at least one repeating unit, gate electrodes of a plurality of first transistors and gate electrodes of a plurality of third transistors are connected with a same scanning signal line.

4. The display substrate according to claim 1, wherein
in at least one repeating unit, the scanning signal line extends from the display region to the light-transmitting region,
the scanning signal line comprises a single-line segment of a single-line structure and a double-line segment of a double-line structure,
the single-line segment is disposed in the light-transmitting region,
the double-line segment is disposed in the display region, and
the double-line segment is respectively connected with pixel driving circuits of the plurality of sub-pixels in the repeating unit.

5. The display substrate according to claim 4, wherein
the double-line segment comprises a first sub-line and a second sub-line,
the first sub-line and the second sub-line extend along a pixel row direction,
the first sub-line and the second sub-line are arranged along a pixel column direction,
the first sub-line is respectively connected with pixel driving circuits of a plurality of sub-pixels in one pixel row, and
the second sub-line is respectively connected with pixel driving circuits of a plurality of sub-pixels in another adjacent pixel row.

6. The display substrate according to claim 5, wherein the double-line segment further comprises a first connection line and a second connection line,
the first connection line is connected with one terminal of the first sub-line and the second sub-line respectively,
the second connection line is connected with the other terminal of the first sub-line and the second sub-line respectively, and
the first connection line, the first sub-line, the second connection line, and the second sub-line constitute a ring-shaped structure.

7. The display substrate according to claim 6, wherein the single-line segment is located in an extension direction of the first sub-line or the second sub-line.

8. The display substrate according to claim 6, wherein
the first connection line is connected with the single-line segment located in a light-transmitting region on one side of the display region in the pixel row direction, and
the second connection line is connected with the single-line segment located in a light-transmitting region on the other side of the display region in a direction opposite to the pixel row direction.

9. The display substrate according to claim 8, wherein in the at least one repeating unit, the single-line segment and the double-line segment are interconnected as an integral structure.

10. The display substrate according to claim 6, wherein orthographic projections of the first power supply line, the data signal line, and the compensation signal line on a plane of the display substrate at least partially overlap with an orthographic projection of the ring-shaped structure on the plane of the display substrate.

11. The display substrate according to claim 6, wherein
in the at least one repeating unit, active layers of the third transistors of two sub-pixels in adjacent pixel rows are interconnected as an integral structure, and
orthographic projections of the active layers of the third transistors on the plane of the display substrate at least partially overlap with an orthographic projection of the ring-shaped structure on the plane of the display substrate.

12. The display substrate according to claim 1, wherein in the at least one repeating unit, the plurality of sub-pixels are mirror-symmetrical with respect to the scanning signal line.

13. The display substrate according to any one of claims 1 to 12, wherein
a first terminal of the storage capacitor comprises a first electrode plate and a third electrode plate,
a second terminal of the storage capacitor comprises a second electrode plate,
an orthographic projection of the second electrode plate on the plane of the display substrate at least partially overlaps with an orthographic projection of the first electrode plate on a plane of the display substrate,
the first electrode plate and the second electrode plate form a first capacitor,
an orthographic projection of the second electrode plate on the plane of the display substrate at least partially overlaps with an orthographic projection of the third electrode plate on the plane of the display substrate,
the third electrode plate and the second electrode plate form a second capacitor,
the first electrode plate is respectively connected with the third electrode plate,
the second electrode of the first transistor and the gate electrode of the second transistor, the second electrode plate is respectively connected with the second electrode of the second transistor and the second electrode of the third transistor, and
the first capacitor and the second capacitor constitute the storage capacitor with a parallel structure.

14. The display substrate according to claim 13, wherein
in a direction perpendicular to the display substrate, the display region comprises a drive circuit layer disposed on a base substrate and a light-emitting structure layer disposed on a side of the drive circuit layer away from the base substrate, the drive circuit layer comprises at least a first conductive layer, a second conductive layer, and a third conductive layer which are disposed sequentially along a direction away from the base substrate, the first electrode plate is disposed in the first conductive layer, the second electrode plate is disposed in the second conductive layer, the third electrode plate is disposed in the third conductive layer, and the third electrode plate is connected with the first electrode plate through a via; and
the at least one repeating unit further comprises an electrode plate connection electrode, the electrode plate connection electrode is disposed in the light-transmitting region, and the electrode plate connection electrode is connected with the first electrode plate.

15. The display substrate according to claim 14, wherein in the at least one repeating unit, the electrode plate connection electrode and the first electrode plate are interconnected as an integral structure.

16. The display substrate according to claim 14, wherein
the light-emitting structure layer comprises at least a fourth conductive layer disposed on a side of the third conductive layer away from the base substrate, the fourth conductive layer comprises at least a first anode and an anode connection electrode, the first anode is disposed in the plurality of sub-pixels of the display region, the anode connection electrode is disposed in the light-transmitting region, the anode connection electrode is connected with the electrode plate connection electrode through an anode via, and the anode via is disposed in the light-transmitting region; and
in the at least one sub-pixel, the first anode comprises a first sub-anode and a second sub-anode disposed in isolation, a first terminal of the anode connection electrode is connected with the first sub-anode, and a second terminal of the anode connection electrode is connected with the second sub-anode.

17. The display substrate according to claim 14, wherein the third conductive layer further comprises a second power supply line and a first auxiliary electrode, the second power supply line is disposed in the display region, the first auxiliary electrode is disposed in the light-transmitting region, and the first auxiliary electrode is connected with the second power supply line.

18. The display substrate according to claim 17, wherein in the at least one repeating unit, the first auxiliary electrode and the second power supply line are interconnected as an integral structure.

19. The display substrate according to claim 17, wherein an orthographic projection of the second power supply line on the plane of the display substrate at least partially overlaps with an orthographic projection of the ring-shaped structure of the scanning signal line on the plane of the display substrate.

20. A display device, comprising the display substrate according to any one of claims 1 to 19.

21. A manufacturing method of a display substrate, wherein:
the display substrate comprises a plurality of repeating units arranged regularly, the repeating units comprise a display region and a light-transmitting region located in at least one side of the display region, the display region is configured to perform image display, and the light-transmitting region is configured to transmit light; the display region comprises a plurality of sub-pixels forming at least two pixel rows and two pixel columns, the sub-pixels include a pixel driving circuit;
the manufacturing method comprises forming a pixel driving circuit in the sub-pixels; and
the pixel driving circuit comprises a first transistor, a second transistor, a third transistor and a storage capacitor, a first electrode of the first transistor is connected with a data signal line, a second electrode of the first transistor is connected with a gate electrode of the second transistor and a first terminal of the storage capacitor, a first electrode of the second transistor is connected with a first power supply line, a second electrode of the second transistor is connected with a second electrode of the third transistor and a second terminal of the storage capacitor respectively, a first electrode of the third transistor is connected with a compensation signal line, and a gate electrode of the first transistor and a gate electrode of the third transistor are connected with a same scanning signal line.
